(19) Europäisches Patentamt European Patent Office Office européen des brevets

(11) **EP 1 780 813 A1**

(12) **EUROPEAN PATENT APPLICATION**
published in accordance with Art. 158(3) EPC

(43) Date of publication:
02.05.2007 Bulletin 2007/18

(21) Application number: 05753274.9

(22) Date of filing: 23.06.2005

(51) Int Cl.:
*H01L 41/083* (2006.01)     *H01L 41/187* (2006.01)
*H01L 41/22* (2006.01)     *H02N 2/00* (2006.01)

(86) International application number:
**PCT/JP2005/011539**

(87) International publication number:
**WO 2006/001334 (05.01.2006 Gazette 2006/01)**

(84) Designated Contracting States:
DE FR GB

(30) Priority: 24.06.2004 JP 2004186471
27.09.2004 JP 2004278625

(71) Applicant: Kyocera Corporation
Kyoto-shi, Kyoto-fu 612-8501 (JP)

(72) Inventors:
• NAKAMURA, Shigenobu,
c/o KYOCERA CORPORATION
Kokubu-shi, agoshima 8994396 (JP)

• KONDO, Mitsuo,
c/o KYOCERA CORPORATION
Kokubu-shi, Kagoshima 8994396 (JP)
• SATO, Masahiro,
c/o KYOCERA CORPORATION
Kokubu-shi, Kagoshima 8994396 (JP)

(74) Representative: HOFFMANN EITLE
Patent- und Rechtsanwälte
Arabellastrasse 4
81925 München (DE)

(54) **MULTILAYER ELECTRONIC COMPONENT AND INJECTION SYSTEM USING SAME**

(57) A multi-layer electronic component comprising: a stack having an effective region formed by stacking at least one dielectric layer and a plurality of internal electrodes consisting of first and second internal electrodes one on another and protective layers provided on both ends of the effective region in the stacking direction; and external electrodes formed on two side faces of the stack with one of which being connected to the first internal electrode and the other external electrode being connected to the second internal electrode, wherein the effective region consists of an active region where adjacent first internal electrode and second internal electrode oppose each other and an inactive region located outside of the active region in which the first internal electrodes or the second internal electrodes oppose each other, and wherein the active region and the inactive region have different colors to appreciate a border between the displacement section and no-displacement section obviously.

Fig. 1A

**EP 1 780 813 A1**

**Description**

TECHNICAL FIELD

The present invention relates to a multi-layer electronic component and is used in, for example, multi-layer ceramic capacitor and multi-layer piezoelectric element. The present invention relates particularly to a multi-layer electronic component such as multi-layer piezoelectric actuator used in piezoelectric transducer, fuel injection apparatus of automobile engine, or a drive unit used in precision positioning device or vibration preventing device for an optical apparatus, and to an injection apparatus using the same.

BACKGROUND ART

For example, multi-layer piezoelectric actuators constituted from piezoelectric layers and internal electrodes stacked alternately one on another have been known as a multi-layer electronic component. The multi-layer piezoelectric actuator comprises a piezoelectric element which undergoes an expansion ranging from several micrometers to several tens of micrometers when a voltage is applied thereto so as to serve as the drive unit of an actuator. The multi-layer piezoelectric actuators can be divided into two categories: fired-at-once type and stacked type which has such a constitution as piezoelectric porcelain and internal electrodes are stacked alternately one on another. When the requirements to reduce the operating voltage and the manufacturing cost are taken into consideration, the multi-layer piezoelectric actuator of fired-at-once type is more advantageous for the reason of smaller layer thickness.

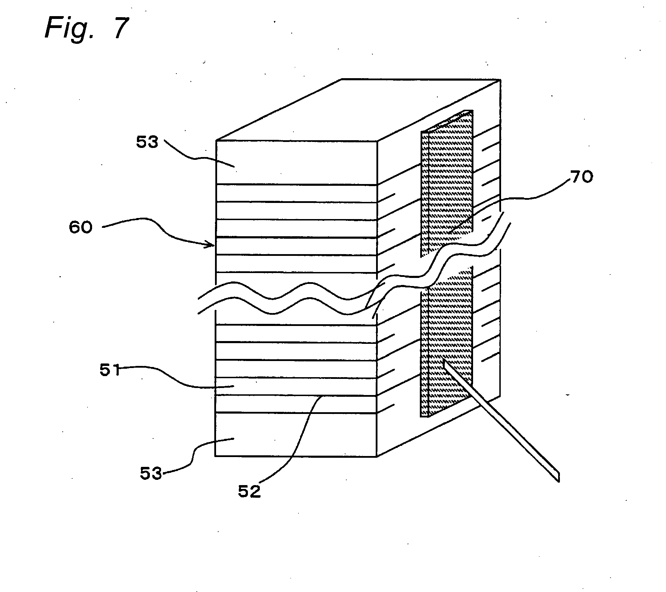

Fig. 7 shows a multi-layer piezoelectric actuator of the prior art. The multi-layer piezoelectric actuator is constituted from an effective section consisting of piezoelectric layers 51 and internal electrodes 52 stacked alternately one on another and a stack 60 which has protective layers 53 provided on both ends of an effective section in the stacking direction.

In a displacement section comprising positive and negative internal electrodes 52 stacked alternately one on another, the positive and negative internal electrodes 52 are exposed on the side faces of the stack 53 alternately. In a no-displacement section where either the positive electrode or the negative electrode is stacked, only the internal electrode 52 of one polarity is exposed on the side face of the stack 60. On side face of the no-displacement section where only the internal electrode 52 of one polarity is exposed, external electrodes 70 are formed. That is, the positive and negative external electrodes 70 are formed in the no-displacement section which is exposed on two opposing side faces of the stack 60, while the positive and negative internal electrodes stacked alternately one on another in the displacement section are connected to the external electrodes 70 in every other layer.

The multi-layer electronic component such as the multi-layer piezoelectric actuator having the constitution described above is manufactured by printing a paste for the internal electrode on ceramic green sheets, and forming a column-like stack comprising a plurality of ceramic green sheets having the paste for the internal electrodes printed thereon (refer to, for example, Japanese Unexamined Patent Publication (Kokai) No. 2001-181055).

Specifically, the paste for the internal electrode is printed in a predetermined pattern of the electrode structure on ceramic green sheets that include the substance used for making the piezoelectric material, and a plurality of the ceramic green sheets having the paste for the internal electrodes printed thereon are stacked so as to make a compact of the stack. The compact is fired to obtain the stack. Then the external electrodes are formed on a pair of side faces of the stack thereby to make the multi-layer piezoelectric element (refer to, for example, Japanese Unexamined Utility Model Publication (Kokai) No. 61-133715).

The internal electrode 52 is formed from an alloy of silver and palladium and, in order to fire the piezoelectric layers 51 and the internal electrodes 52 at the same time, composition of metals contained in the internal electrode 52 has been set typically to 70% by weight of silver and 30% by weight of palladium (refer to, for example, patent Published Japanese Translation No. 12-508835 of the PCT Application).

The reason for using the internal electrode 52 made of a metal compound that contains a silver-palladium alloy instead of the internal electrode having composition constituted from pure silver is that, piezoelectric ceramic material constituted from perovskite type oxide consisting of the common composition of $PbZrO_3$- $PbTiO_3$ as the main component has firing temperature of 1200 to 1300°C, higher than the melting point of silver. As silver contained in the internal electrodes 52 diffuses into the piezoelectric layers 51 during firing thereby accelerating the growth of grains, optimum crystal grains can be obtained through the growth of grains accelerated by the effect of diffusing silver even when the firing temperature is lower than that in the case of only the piezoelectric material is fired, by 100 to 200°C. The composition constituted from pure silver without palladium suffers from the so-called silver migration in which silver atoms migrate from the positive electrode to the negative electrode of the pair of internal electrodes 52 along the device surface, when a voltage is applied across a pair of opposing internal electrodes 52. Silver migration occurs conspicuously particularly in an atmosphere of high temperature and high humidity.

When the multi-layer piezoelectric element of the prior art is used as a piezoelectric actuator, lead wires are secured onto the external electrodes 70 by soldering, and a predetermined voltage is applied across the external electrodes 70 so as to operate the device. In recent years, it is a common practice to operate the multi-layer piezoelectric element continuously over a long period of time with a higher electric field applied, since it is required to achieve a large amount of displacement from a compact multi-layer piezoelectric element under a higher pressure.

DISCLOSURE OF THE INVENTION

However, there have been such a problem in the multi-layer piezoelectric element of the prior art as the border between displacement section and no-displacement section is not clear enough to form the external electrode only in the no-displacement section. In case the external electrode is formed also in the displacement section, the internal electrodes of different polarities are put into electrical continuity with each other by the external electrode, thus resulting in insulation failure occurring on the side face of the stack. In case the distance between the external electrode and the displacement section (length of the no-displacement section along the shorter side thereof) is short, there has been a possibility of short-circuiting occurring between the external electrode exposed on the side face of the stack and the internal electrode of the opposite polarity during operation with high electric field intensity.

Measurement of the width of the no-displacement section and of the distance between the external electrode and the displacement section requires it to use an optical instrument of high magnifying power for the observation of an end of the internal electrode, which takes a long time.

Measurement of thickness of the protective layer also requires it to use an optical instrument of high magnifying power for the observation of the position of the internal electrodes in the top layer and the bottom layer in the stacking direction of the stack, which takes a long time.

Moreover, while it is necessary to connect the external electrodes to all the internal electrodes of the same polarity located in the no-displacement section of the effective region, it has been difficult to form the external electrodes in the entire region of the no-displacement section of the effective region in the stacking direction.

In the meantime, there has been such a problem that, when the external electrodes are formed over the entire region of the protective layer, insulation of metal members formed on the top and bottom of the stack may fail. While it is necessary to keep the external electrodes in electrical continuity with the internal electrode located in the no-displacement section of the effective region and form the external electrode in a region which does not reach the top or bottom end of the protective layer, it has been difficult to form the external electrodes within the region.

In recent years, in order to achieve a large amount of displacement with high response characteristic, it is required to operate the multi-layer piezoelectric actuator by applying a high voltage of high frequency. This results in short-circuiting between terminals of the internal electrodes whereon voltages of different polarities are applied, thus lowering the operation of the multi-layer piezoelectric actuator.

The multi-layer piezoelectric actuator of the prior art has been made by preparing a slurry constituted from a stock material powder and a binder made of an organic polymer, forming the slurry into green ceramic sheets which would become the piezoelectric layers 1 by a known method such as doctor blade process, calender roll process, slip casting process or other tape molding method, form the internal electrodes on the sheets and stacking the green ceramic sheets so as to form the column-shaped stack. This method has such problems as foreign matter can mix in, and the tendency of tape thickness to fluctuate due to uneven drying or other factors may cause the distance between the internal electrodes 2 to decrease, thus giving rise to the possibility of short-circuiting occurring between the internal electrodes 2. The fluctuation becomes more significant when the sheet thickness is increased in order to increase the insulation.

There has been the problem of short-circuiting occurring between the internal electrodes, as described above, during operation by applying a high voltage of high frequency in order to achieve a large amount of displacement with high response characteristic.

Particularly when operated in an atmosphere of high temperature and high humidity, there has been the problem that short-circuiting is likely to occur between the internal electrodes between which different voltage is applied across the internal electrodes, due to migration of the component of the electrode.

Accordingly, first object of the present invention is to provide a multi-layer electronic component in which borders between the displacement section, the no-displacement section and the protective layer can be clearly identified, insulation failure does not occur between the external electrode and the displacement section, and it is easy to inspect and measure the width of the no-displacement section, the distance between the external electrode and the displacement section and thickness of the inactive section.

Second object of the present invention is to provide a multi-layer electronic component in which short-circuiting can be suppressed from occurring between the internal electrodes even when operated under a high voltage in an atmosphere of high temperature and high humidity.

Third object of the present invention is to provide a multi-layer piezoelectric element and an injection apparatus which have high durability and allow it to increase the amount of displacement of the multi-layer piezoelectric actuator under high voltage and high pressure and do not changes in the amount of displacement even when operated continuously over a long period of time.

In order to achieve the objects described above, first multi-layer electronic component according to the present invention comprises a stack comprising an effective region formed by stacking at least one dielectric layer and a plurality of internal electrodes consisting of first and second internal electrodes one on another and protective layers provided on both ends of the effective region in the stacking direction, and external electrodes formed on two side faces of the stack with one of which being connected to the first internal electrode and the other external electrode being connected to the second internal electrode, wherein the effective region consists of an active region where adjacent first internal electrode and second internal electrode oppose each other and an inactive region located outside of the active region in which the first internal electrodes or the second internal electrodes oppose each other, and the active region and the inactive region have different colors.

In the first multi-layer electronic component of the present invention, it is preferable that color difference ΔE*ab in the L*a*b* color system between the active region and the inactive region is 1.0 or larger.

Second multi-layer electronic component according to the present invention comprises a stack comprising an effective region formed by stacking at least one dielectric layer and a plurality of internal electrodes consisting of first and second internal electrodes one on another and protective layers provided on both ends of the effective region in the stacking direction, and external electrodes formed on two side faces of the stack with one of which being connected to the first internal electrode and the other external electrode being connected to the second internal electrode, wherein the effective region and the protective layers have different colors.

In the second multi-layer electronic component of the present invention, it is preferable that color difference ΔE*ab in the L*a*b* color system between the effective region and the protective layers is 1.0 or larger.

Third multi-layer electronic component according to the present invention comprises a stack made by stacking a plurality of dielectric layers and a plurality of internal electrodes, wherein the dielectric layer has thickness of 50μ m or more and variation in the thickness of the dielectric layer is within 10 μm.

Fourth multi-layer electronic component according to the present invention comprises a stack formed by stacking at least one piezoelectric layer and a plurality of internal electrodes consisting of first and second internal electrodes one on another, and external electrodes formed on two side faces of the stack with one of which being connected to the first internal electrode and the other external electrode being connected to the second internal electrode, wherein the piezoelectric layer contains 0.01 to 1% by weight of group VIII metal and/or group Ib metal.

Injection apparatus of the present invention comprises a container having an injection hole, one of the first to fourth multi-layer electronic components which is store in the container and undergoes expansion and contraction in the stacking direction in response to a voltage applied between first and second internal electrodes, and a valve which allows a liquid to spout out of the injection hole when the multi-layer electronic component is driven to operate.

The multi-layer electronic component of the present invention is manufactured by preparing dielectric material sheets having thickness of 50 μm or more and variation in the thickness within 10 μm from a slurry which contains a dielectric material by a tape forming method, printing the internal electrodes on the sheets, stacking the sheets and firing the stack.


EFFECT OF THE INVENTION

In the first multi-layer electronic component of the present invention having the constitution described above, since the active region and the inactive region have different colors, the border between the active region and the inactive region is clear so that such problems can be prevented from occurring as a part of the external electrode is formed on the side face of the active region or the distance between external electrode and the active region becomes smaller, so as to prevent insulation failure from occurring between the external electrode and a side face of the active region. In the multi-layer electronic component, in case the multi-layer piezoelectric actuator is constituted by using the dielectric material as the piezoelectric material, the problem of short-circuiting occurring between the external electrode and a side face of the active region (the displacement section) can be prevented from occurring even when the device is operated with a high electric field.

In the first multi-layer electronic component of the present invention, when color difference ΔE*ab in the L*a*b* color system between the active region and the inactive region is 1.0 or larger, the border between the active region and the inactive region can be identified easily with an optical instrument, so that the width of the inactive region and the distance between the external electrode and the active region can be easily measured. Moreover, when a part of the external electrode is formed on the side face of the active region or the distance between external electrode and the active region becomes smaller, the trouble can be easily detected.

As a result, sophisticated inspection process can be eliminated and therefore the multi-layer electronic component of high reliability can be manufactured at a low cost.

In the second multi-layer electronic component of the present invention, since the effective region and the protective layer have different colors, the border between the effective region and the protective layers is clear so that products having such problems can be easily identified as the protective layer is too thin and allows cracks to occur in the top and bottom surfaces of the stack. Products where the external electrodes are not connected to all the internal electrodes of the same polarity can also be easily identified. While it is necessary to connect the external electrodes to all of the internal electrodes of the same polarity located in the inactive region of the effective region, forming the effective region and the protective layer with different colors makes the border between the effective region and the protective layers clearer, thereby making it possible to make sure that the external electrodes are formed in the entire region in the stacking direction of the inactive region and are connected to the internal electrodes.

In the second multi-layer electronic component of the present invention, when color difference $\Delta E^*ab$ in the $L^*a^*b^*$ color system between the effective region and the protective layers is 1.0 or larger, the border between the protective layer and the displacement section and the border between the protective layer and the no-displacement section can be identified easily with an optical instrument, so that efficiency of inspection can be greatly improved and the multi-layer electronic component can be manufactured at a low cost.

In the third multi-layer electronic component of the present invention, since thickness of the dielectric layer is 50 $\mu$m or more and variation in the thickness is within 10 $\mu$m, short-circuiting between the internal electrodes can be suppressed and high durability can be maintained under a high voltage in an atmosphere of high temperature and high humidity. Particularly in a multi-layer piezoelectric actuator which is operated under a high voltage, short-circuiting between the internal electrodes can be suppressed.

In the fourth multi-layer electronic component of the present invention, since the piezoelectric layer contains 0.01 to 1% by weight of group VIII metal and/or group Ib metal, the amount of displacement of the multi-layer piezoelectric actuator can be increased under high voltage and high pressure, and changes in the amount of displacement can be suppressed even when operated continuously over a long period of time, so as to provide the multi-layer piezoelectric element having high durability.

Since the injection apparatus of the present invention contains one of the first through fourth multi-layer electronic components, the multi-layer electronic component and the injection apparatus having high durability can be provided.

The multi-layer electronic component of the present invention is manufactured by preparing dielectric material sheets having thickness of 50 $\mu$m or more and variation in the thickness within 10 $\mu$m from a slurry which contains a dielectric material by a tape forming method, printing the internal electrodes on the sheets, stacking the sheets and firing the stack, so that the multi-layer electronic component having the capability to prevent short-circuiting between the internal electrodes, and high durability under a high voltage in an atmosphere of high temperature and high humidity can be maintained.


BRIEF DESCRIPTION OF THE DRAWINGS

Fig. 1A is a perspective view showing the constitution of the multi-layer electronic component according to the first embodiment of the present invention.
Fig. 1B is a sectional view of Fig. 1A taken along lines A-A'.
Fig. 1C is a partially enlarged view of a part of Fig. 1B.
Fig. 2 is an exploded perspective view showing the internal electrode pattern of multi-layer electronic component according to the first embodiment.
Fig. 3 is a perspective view showing the constitution of the multi-layer electronic component according to the second embodiment of the present invention.
Fig. 4A is a perspective view showing the constitution of the multi-layer electronic component according to the third embodiment of the present invention.
Fig. 4B is an exploded perspective view showing the internal electrode pattern of the multi-layer electronic component according to ,the third embodiment.
Fig. 5 is a sectional view showing the constitution of the injection apparatus according to the fourth embodiment of the present invention.
Fig. 6 is a graph showing the result of measurement of the concentration of metal component in the piezoelectric layer of the multi-layer piezoelectric element according to the third embodiment of the present invention.
Fig. 7 is a perspective view of a multi-layer piezoelectric actuator of the prior art.


[Description of Reference Numerals]

1:              piezoelectric layer

| 2: | internal electrode |
|---|---|
| 4: | external electrode |
| 6: | lead wire |
| 10: | effective region |
| 10a: | active region (displacement section) |
| 10b: | inactive region (no-displacement section) |
| 11: | protective layer |
| 31: | container |
| 33: | injection hole |
| 35: | valve |
| 43: | piezoelectric actuator |
| 102, 111, 113: | stack |

BEST MODE FOR CARRYING OUT THE INVENTION

The multi-layer electronic component according to the embodiment of the present invention will now be described with reference to the accompanying drawings.

First Embodiment 1

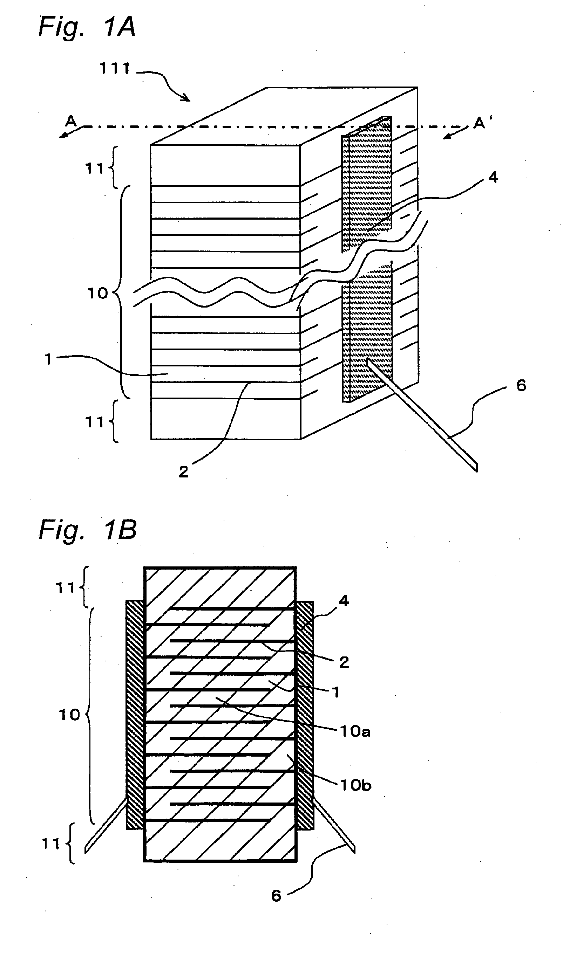

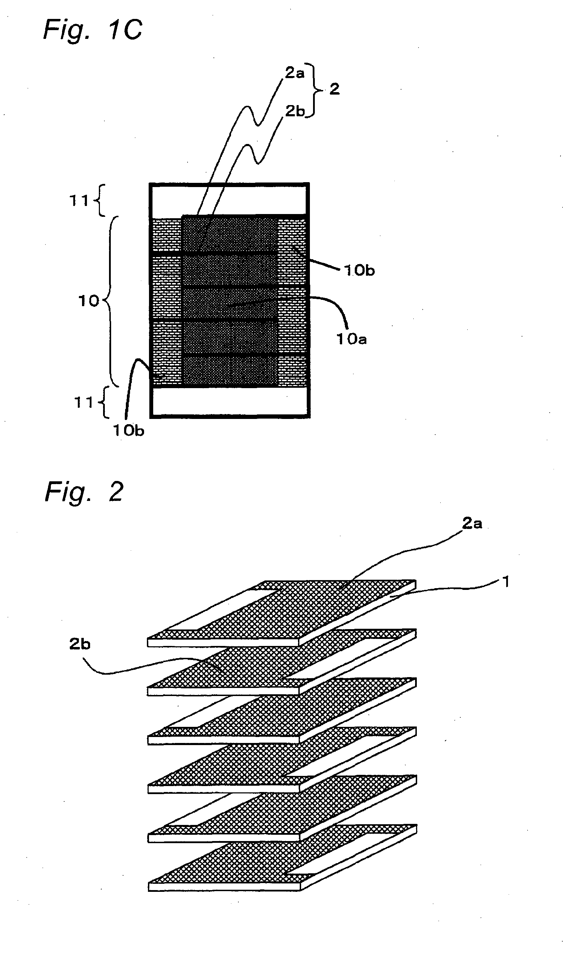

Fig. 1A, Fig. 1B and Fig. 1C show the constitution of multi-layer piezoelectric actuator which is one form of the multi-layer electronic component according to the first embodiment of the present invention, Fig. 1A being a perspective view, Fig. 1B being a sectional view of Fig. 1A taken along lines A-A' and Fig. 1C being a partially enlarged view of a part of Fig. 1B.
The multi-layer piezoelectric actuator of the first embodiment has such a constitution, as shown in Fig. 1A, that a pair of external electrodes 4 are provided on the side faces of a stack 111 comprising an effective region 10 formed by stacking piezoelectric layers 1 and internal electrodes 2 alternately one on another, and protective layers 11 provided on both ends of the effective region 10 in the stacking direction. As shown in Fig. 1B and Fig. 1C, the effective region 10 is constituted from an active region 10a where the piezoelectric layer 1 is interposed between a first internal electrode 2a which is connected to the positive one of the pair of external electrodes 4 and a second internal electrode 2b which is connected to the other negative one of the pair of external electrodes 4 (hereinafter referred to as displacement section 10a), and an inactive region 10b where the piezoelectric layer 1 is interposed between the first internal electrodes 2a or between the second internal electrodes 2b (hereinafter referred to as no-displacement section 10b). In other words, the external electrodes 4 are formed on the respective side faces of the no-displacement section 10b so as to connect with either one of the first internal electrode 2a or the second internal electrode 2b, and are isolated from the other internal electrode 2 which is not connected. While the other external electrode 4 is defined as negative electrode in the first embodiment, it may also be a ground terminal.
The internal electrodes 2 are formed from a metal such as silver-palladium, through which a predetermined voltage is applied to the piezoelectric layer 1 so as to cause displacement of the piezoelectric layer 1 by the reverse piezoelectric effect.
The protective layers 11 are plurality of layers of the piezoelectric material 1 which are not provided with the internal electrodes 2, and therefore do not undergo displacement even when the voltage is applied via the external electrodes 4. The protective layers 11 may be formed from the same material as the piezoelectric layer 1, or from a different material.
Distance between the internal electrodes 2 in the no-displacement section 10b, namely the distance between the first internal electrodes 2a or distance between the second internal electrodes 2b is about twice the distance between the internal electrodes 2 in the displacement section 10a.
The external electrodes 4 are joined to the opposing side faces of the stack 111, and the internal electrodes 2 stacked in the displacement section are electrically connected to the external electrodes 4 in every other layer, so as to supply the voltage required to make displacement by the reverse piezoelectric effect of the piezoelectric layer 1 interposed by the internal electrodes 2.
The external electrodes 4 are also provided with lead wires 6 connected thereto by soldering or the like, so as to connect the external electrodes 4 via the lead wires 6 to a power source provided outside.
According to the first embodiment, the piezoelectric layer 1 is formed, for example, from piezoelectric ceramic material which contains lead titanate zirconate $Pb(Zr-Ti)O_3$ (hereinafter abbreviated as PZT) or barium titanate $BaTiO_3$ as the main component. The piezoelectric ceramic material preferably has a high value of piezoelectric strain constant $d_{33}$ which represents the piezoelectric characteristic.
The thickness of the piezoelectric layer 1, namely the distance between the internal electrodes 2 in the displacement section 10a is preferably in a range from 50 to 250 $\mu$m. When the thickness of the piezoelectric layer 1 is set within this range, the multi-layer piezoelectric actuator can be made in a compact and low profile construction despite increasing number of layers stacked for the purpose of achieving a larger amount of displacement, and it is made possible to prevent insulation breakdown from occurring in the piezoelectric layer 1.

The internal electrodes 2 (the first internal electrode 2a and the second internal electrode 2b) in the effective section 10 are connected to the external electrodes 4 of the same polarity on one end thereof, and are isolated from the external electrodes 4 of the opposite polarity on the other end thereof. For this reason, the internal electrodes 2 are partially chipped away on either side. For example, positive and negative internal electrodes are stacked alternately in such a configuration as shown in Fig. 2. The positive and negative internal electrodes are not restricted to the configuration as shown in Fig. 2, and may have the same shape or different shapes as long as the internal electrodes 2 are connected to the external electrodes 4 on one end and are isolated from the external electrodes 4 of the opposite polarity on the other end.

Thus the effective region 10 is constituted from the displacement section 10a where the positive and negative internal electrodes 2 are stacked consecutively and the no-displacement section 10b where only the internal electrodes 2 of one polarity are stacked.

The multi-layer piezoelectric actuator of the first embodiment is characterized in that the displacement section 10a and the no-displacement section l0b are formed with different colors. As the displacement section l0a and the no-displacement section 10b are formed to have difference in colors thereof, the border between the displacement section 10a and the no-displacement section 10b is made clearer and such problems can be prevented from occurring as a part of the external electrode 4 is formed on the side face of the displacement section l0a or the distance between the external electrode 4 and the displacement section 10a becomes smaller, so as to prevent insulation failure from occurring between the external electrode 4 and the internal electrode 2 of the opposite polarity exposed on the side face of the displacement section 10a, or short-circuiting occurring between the external electrode 4 and the internal electrode 2 of the opposite polarity exposed on the side face of the displacement section 10a can be prevented from occurring even when the device is operated with a high electric field.

The displacement section 10a and no-displacement section 10b can be formed to have difference in colors by, for example, forming the piezoelectric layers 1 and the internal electrodes 2 with significantly different colors, or controlling the distance between the internal electrodes 2 or the number of layers to be stacked. Method of differentiating the color will be described in detail later.

It is preferable that color difference $\Delta$E*ab in the L*a*b* color system of the displacement section 10a and the no-displacement section 10b is 1.0 or larger. When the color difference $\Delta$E*ab is less than 1.0, the border between the displacement section 10a and the no-displacement section 10b becomes less clear, and the possibility becomes higher that a part of the external electrode 4 is formed on the side face of the displacement section l0a and insulation failure occurs between the external electrode 4 and the internal electrode 2 of the opposite polarity exposed on the side face of and the displacement section 10a, when the external electrodes 4 are formed on the side faces of the stack 1a. Even when a part of the external electrode 4 is not formed on the side face of the displacement section 10a, if the distance between the external electrode 4 and the displacement section l0a is short, there is a possibility of short-circuiting between the external electrode 4 and the internal electrode 2 of the opposite polarity exposed on the side face of and the displacement section 10a, when the actuator is operated with a high electric field.

In the multi-layer piezoelectric actuator of the first embodiment, the effective region 10 and the protective layers 11 are preferably formed with different colors. As the effective region 10 and the protective layers 11 are formed with different colors, it becomes easier to measure the thickness of the protective layer 11, so that it can be checked to see whether the protective layer 11 is formed with the predetermined thickness or not. When the protective layer 11 is too thin, cracks may occur in the top and bottom ends of the protective layer 11 during continuous operation of the multi-layer piezoelectric actuator with high electric field. The crack may grow into the internal electrode 2 thereby causing short-circuiting. When the protective layer 11 is too thick, on the other hand, it contradicts with the trend toward lower profile of electronic components which are becoming increasingly smaller. As the effective region 10 and the protective layers 11 are formed with different colors, it becomes easier to identify a product of which protective layer 11 is too thin to prevent short-circuiting. Moreover, it is made possible to polish so that the protective layers 11 located at the top and bottom ends of the stack 1a in the stacking direction have the same thickness, and the protective layers 11 can be easily finished to a thickness that is minimum necessary to prevent short-circuiting from occurring.

It is preferable that color difference $\Delta$E*ab in the L*a*b* color system of the effective region 10 and the protective layers 11 is 1.0 or larger. When the color difference $\Delta$E*ab is less than 1.0, the border between the effective region 10 and the protective layers 11 becomes less clear, and it becomes difficult to measure the thickness of the protective layer 11. When the thickness of the protective layers 11 is too thin, cracks may occur in the top and bottom ends of the protective layer 11 during operation of the actuator at a high speed with large force, while the crack reaching the internal electrode 2 may cause short-circuiting.

When the color difference $\Delta$E*ab is less than 1.0, the border between the effective region 10 and the protective layers 11 becomes less clear, and it becomes difficult to determine whether the external electrodes 4 are formed over the entire region of the effective section 10 in the stacking direction. In case the external electrodes 4 are not formed over the entire region of the effective section 10 in the stacking direction, part of the internal electrodes 2 cannot be connected to the external electrodes 4, thus giving rise to the possibility of a problem that the amount of displacement decreases.

It is preferable that color difference ΔE*ab in the L*a*b* color system between the piezoelectric layers 1 and the internal electrodes 2 is 1.5 or larger. When the color difference ΔE*ab between the piezoelectric layers 1 and the internal electrodes 2 is less than 1.5, color difference cannot be changed effectively, for the reason to be described later, in the displacement section 10a which is the region of the piezoelectric layer 1 that is interposed between the internal electrodes of the other polarity, the no-displacement section 10b which is the region of the piezoelectric layer 1 that is interposed between the internal electrodes 2 of the same polarity and the protective layer 11 which is the region of the piezoelectric layer that is not interposed between the internal electrodes 2.

Color difference ΔE*ab in the L*a*b* color system can be calculated by the equations 1 through 4 described below. Lightness index L* and chromaticness indices a* and b* which represent hue and chroma are measured with a spectrocolorimeter, so as to determine the lightness difference ΔL* and chromaticness differences Δa* and Δb* between two objects, thereby calculating the color difference ΔE*ab by the following equations (numerals (1) and (2) denote the objects 1 and 2, respectively).

$$\Delta L^* = L^*(1) - L^*(2) \qquad \text{Equation 1}$$

$$\Delta a^* = a^*(1) - a^*(2) \qquad \text{Equation 2}$$

$$\Delta b^* = b^*(1) - b^*(2) \qquad \text{Equation 3}$$

$$\Delta E^*ab = [(\Delta L^*)^2 + (\Delta a^*)^2 + (\Delta b^*)^2]^{1/2} \qquad \text{Equation 4}$$

The method for manufacturing the multi-layer piezoelectric actuator of the first embodiment will now be described.

In order to make the multi-layer piezoelectric actuator of the first embodiment, first, a calcined powder of a piezoelectric ceramic material constituted from PZT or the like, a binder made of an organic polymer such as acrylic resin or butyral resin and a plasticizer such as DBP (dibutyl phthalate) or DOP (dioctyl phthalate) are mixed to form a slurry. The slurry is formed into ceramic green sheets, that would become the piezoelectric layers 1, by doctor blade process, calender roll process or other known tape molding method.

Then silver-palladium powder, a binder, a plasticizer and, as required, the calcined powder of the piezoelectric ceramic material are mixed to prepare an electrically conductive paste that would become the internal electrode 2. This electrically conductive paste is applied onto the top surface of the ceramic green sheets by screen printing method or the like to a thickness of 1 to 40 μm. The paste is not printed on the portion which would become the no-displacement section 10b. A plurality of the green sheets having the electrically conductive paste printed on the top surface thereof to form the positive and negative internal electrodes are stacked one on another so as to make the effective region 10, and a plurality of the green sheets without the electrically conductive paste printed thereon are stacked on the top and bottom of the effective region 10 in the stacking direction, thereby forming the protective layers 11. The stack is heated at a predetermined temperature to remove the binder, and is then fired at a temperature in a range from 900 to 1200°C thereby to make the stack 111.

In order to effectively differentiating the colors of the displacement section 10a, the no-displacement section 10b and the protective layer 11, in case $PbZrO_3$-$PbTiO_3$ is used as the main component, for example, 0.5 mol% or more Yb, W, Nb, Sb, Y, La, Ba, Sr, Ca, or the like may be added as auxiliary component, which enables it to make the piezoelectric layer 1 having higher value of lightness and translucency. A better auxiliary component is addition of 1.0 mol% in total of Yb, Ba and Sr which significantly increases the value of lightness index L*.

When Mn, Cr, Co or the like is added in concentration of 0.5 mol% as an auxiliary component, the piezoelectric layer having low lightness value without translucency can be made.

When the internal electrodes 2 are formed from silver-palladium, colors of the piezoelectric layers 1 and the internal electrodes 2 can be made significantly different by adding the auxiliary component described above so as to improve lightness and translucency, since silver-palladium is a material having relatively low lightness. As a result, lightness of the effective section 10 interposed between the internal electrodes 2 made of silver-palladium which has relatively low value of lightness becomes far lower than that of the protective section 11 which comprises the piezoelectric layers 1 without the internal electrodes 2 provided.

In case the piezoelectric layers 1 is interposed by the internal electrodes 2 in the effective section 10, the value of lightness becomes lower as the distance between the internal electrodes 2 decreases. As a result, the no-displacement section 10b where the internal electrodes 2 are disposed at a distance around twice the thickness of the piezoelectric layers 1 with respect to the displacement section 10a has lightness higher than that of the displacement section 10a. Thus since the displacement section 10a, the no-displacement section 10b and the protective layer 11 have different colors, the borders can be easily identified.

The value of lightness of the piezoelectric layers 1 becomes lower also as the silver component contained in the internal electrodes 2 diffuses into the piezoelectric layers 1. That is, the decrease in the value of lightness of the piezoelectric layers 1 depends on the distance between the internal electrodes 2. The smaller the distance between the internal electrodes 2 which hold the piezoelectric layers 1 therebetween, the more the silver contained in the internal electrodes 2 diffuses into the piezoelectric layers 1, thus resulting in lower value of lightness. That is, the value of lightness increases in the order of the displacement section 10a, the no-displacement section 10b and the protective layer.

In order to have silver contained in the internal electrodes 2 effectively diffuse into the piezoelectric layers 1, proportion of silver contained in silver-palladium which is used to form the internal electrodes 2 is preferably higher. The proportion is 70% or higher, and preferably 85% or higher.

Colors of the displacement section 10a, the no-displacement section 10b and the protective layer 11 can be made different by, instead of significantly differentiating the colors of the piezoelectric layers 1 and the internal electrodes 2 as described above, controlling the thicknesses of the piezoelectric layers 1 and the internal electrodes 2 so as to vary the density of the internal electrodes 2 in the displacement section 10a and in the no-displacement section 10b. That is, the border between the displacement section l0a and the no-displacement section 10b can be made clear by decreasing the thickness of the piezoelectric layers 1 and increasing the thickness of the internal electrodes 2, even when the colors of the piezoelectric layers 1 and the internal electrodes 2 are not made properly different.

Silver-palladium used to form the internal electrodes may be either a powder of silver-palladium alloy or a mixture of silver powder and palladium powder. Silver-palladium alloy can also be formed when fired, by using silver powder and palladium powder.

Method of making the stack 111 is not limited to that described above, and any method may be employed as long as the stack 111 comprising a plurality of piezoelectric layers 1 and a plurality of internal electrodes 2 stacked alternately one on another can be made.

Then a silver-glass paste prepared by adding a binder to a mixture of silver and glass is printed on the side faces of the no-displacement section 10b whereon the external electrodes 4 are to be formed and is fired at a temperature from 500 to 850°C, so as to form the external electrodes 4.

Then the stack 111 is coated with silicone rubber (not shown) on the side faces thereof. After hardening, the lead wires 6 are connected to the external electrodes 4 by soldering or the like, thereby completing the multi-layer piezoelectric actuator of the prevent invention.

Through the lead wires 6, DC voltage of 0.1 to 3 kV/mm is applied between the pair of external electrodes 4 so as to apply polarization treatment to the stack 111, thereby to complete the multi-layer piezoelectric actuator. When the lead wires 6 of the multi-layer piezoelectric actuator are connected to an external voltage source and the voltage is supplied via the lead wires 6 and the external electrodes 4 to the internal electrodes 2, the piezoelectric layers 1 undergo a significant amount of displacement by the reverse piezoelectric effect, so as to drive, for example, an automobile fuel injection valve that supplies fuel to an engine.

Second Embodiment

The multi-layer piezoelectric actuator according to the second embodiment is another form of the multi-layer electronic component of the present invention.

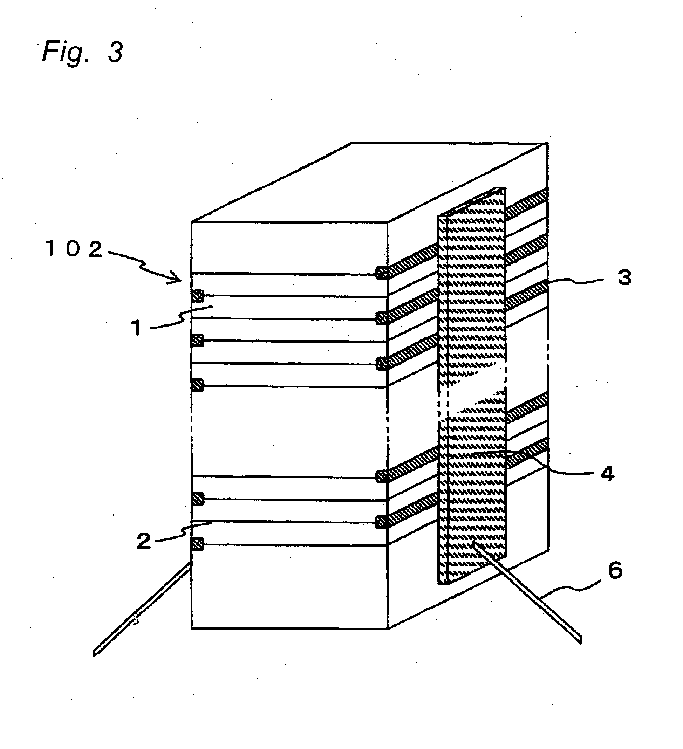

The multi-layer piezoelectric actuator of the second embodiment comprises a stack 102 having a shape of square prism made by stacking a plurality of piezoelectric layers 1 and a plurality of internal electrodes 2 alternately one on another, with ends of the internal electrodes 2 covered by the insulating material 3 alternately in every other layer on the two opposing side faces of the stack 102, ends of the internal electrodes 2 which are not covered by the insulating material 3 being connected to the external electrodes 4, and the lead wires 6 being connected to the external electrodes 4, as shown in Fig. 3.

The piezoelectric layer 1 is interposed between the internal electrodes 2, and a predetermined voltage is supplied via the internal electrodes 2 to the piezoelectric layers 1, so that the piezoelectric layers 1 undergo displacement by the reverse piezoelectric effect.

In the multi-layer piezoelectric actuator of the second embodiment, thickness of the piezoelectric layer 1, namely the distance between the internal electrodes 2, is 50 $\mu$m or more, preferably 70 $\mu$m or more and furthermore preferably 80 $\mu$m or more, while variation in the thickness is 10 $\mu$m or less, preferably 8 $\mu$m or less and furthermore preferably 5 $\mu$m or less. This is because short-circuiting may occur between the internal electrodes 2 and the multi-layer piezoelectric actuator may be destroyed when the distance between the internal electrodes 2 is short or varies significantly.

The thickness of the piezoelectric layer 1, namely the distance between the internal electrodes 2, is defined as the mean of values measured at a plurality of points, and variation thereof is the difference between the maximum value and minimum value.

While the internal electrodes 2 are exposed on the four side faces of the column-shaped stack 102 after being fired, the insulator 3 is formed in the second embodiment by forming a groove having depth of 50 to 500 $\mu$m and width of 30 to 200 $\mu$m in the stacking direction in every other layer on the end face of the piezoelectric layer 1 which includes the end of the internal electrodes 2 on at least one side face, and filling the groove with glass, epoxy resin, polyimide resin, polyamide-imide resin, silicone rubber or the like. This constitution is preferable for the reason of reliability.

The insulator 3 provides isolation of the internal electrodes 2 at the end thereof in every other layer, on two opposing side faces of the column-shaped stack 102, while the other ends of the internal electrodes 2 which are not insulated are connected to the external electrodes 4.

The insulator 3 is preferably made of a material which has a low modulus of elasticity, particularly silicone rubber, which can accommodate the displacement of the column-like stack 102, in order to make the bonding with the column-like stack 102 stronger.

Such a method may also be employed as thin films having low resistance are formed in advance by vapor deposition, sputtering, plating or the like on two opposing side faces of the column-shaped stack 102 where the internal electrodes 2 are exposed, and the external electrodes 4 are connected to the low-resistance thin films.

The external electrodes 4 are also provided with the lead wires 6 connected thereto by soldering or the like, so as to connect the external electrodes 4 via the lead wires 6 to a power source provided outside.

Through the lead wires 6, DC voltage of 0.1 to 3 kV/mm is applied between the pair of external electrodes 4 so as to apply polarization treatment to the column-shaped stack 102, thereby to complete the multi-layer piezoelectric actuator. When the lead wires 6 of the multi-layer piezoelectric actuator are connected to an external voltage source and the voltage is supplied via the external electrodes 4 to the internal electrodes 2, the piezoelectric layers 1 undergo a significant amount of displacement by the reverse piezoelectric effect, so as to drive, for example, an automobile fuel injection valve that supplies fuel to an engine.

Thus the injection apparatus can be constituted from the container having the injection hole, the multi-layer piezoelectric actuator of the present invention housed in the container and the valve which allows a liquid to spout out of the injection hole when the multi-layer electronic component is driven to operate. In the injection apparatus, as described previously, since the amount of displacement does not substantially change when the multi-layer electronic component is operated continuously, the injection apparatus having high durability and high reliability without the possibility of malfunction can be provided.

The method for manufacturing the multi-layer piezoelectric actuator of the second embodiment will now be described.

To manufacture the multi-layer piezoelectric actuator of the second embodiment, first, a calcined powder of a piezoelectric ceramic material constituted from PZT or the like, a binder made of an organic polymer such as acrylic resin or butyral resin, alcohol or an organic solvent such as toluene for dissolving the binder and a plasticizer such as DBP (dibutyl phthalate) or DOP (dioctyl phthalate) are mixed so as to form a slurry. The slurry is formed into ceramic green sheets having thickness of 50 $\mu$m or more, and preferably 55 $\mu$m or more and variation in the thickness within 10 $\mu$m, which would become the piezoelectric layers 1, by a known method such as doctor blade process, calender roll process, slip casting process or other tape molding method.

The slurry has viscosity of preferably 15 poise or higher, more preferably 20 poise or higher and furthermore preferably 25 poise or higher. While greater thickness of the sheets lead to greater variation in thickness, a tape having uniform thickness can be formed by using the slurry of higher viscosity. The slurry having such a level of viscosity is preferably prepared by using a binder made of an organic polymer such as acrylic resin or butyral resin and alcohol, toluene or the like for dissolving the binder.

Then silver-palladium powder, a binder, a plasticizer and, as required, the calcined powder of the piezoelectric ceramic material are mixed to prepare an electrically conductive paste that would become the internal electrode 2. This electrically conductive paste is applied onto the top surface of the ceramic green sheets by screen printing method or the like to a thickness of 1 to 40 $\mu$m.

The green sheets having the electrically conductive paste printed thereon are stacked one on another, cut into desired size and heated to a predetermined temperature so as to remove the binder, before being fired at a temperature from 900 to 1000°C thereby making the column-shaped stack 102. At this time, in order to suppress deformation and decomposition from occurring during firing, it is preferable to fire the stack together with an accompanying material, fire it in an enclosed firing crucible, or in a crucible made of the same material.

The column-shaped stack 102 which has been fired is ground by a surface grinding machine so as to trim the shape. After grinding, it is preferable to apply lapping or polishing by using abrasive particles made of silicon carbide or alumina.

The column-shaped stack 102 comprising a plurality of the piezoelectric layers 1 and a plurality of the internal electrodes 2 stacked alternately one on another is made as described above. The internal electrodes 2 are isolated at the end thereof by the insulator 3 in every other layer on two opposing side faces of the column-shaped stack 102, while the other ends of the internal electrodes which are not insulated are connected to the external electrodes 4, and the lead wires 6 are connected to the external electrodes 4, thereby completing the multi-layer piezoelectric actuator of the present invention.

While the actuator made by stacking a plurality of the piezoelectric layers and a plurality of the internal electrodes has been described as the second embodiment, the multi-layer electronic component of the present invention is not limited to the multi-layer piezoelectric actuator. For example, the multi-layer electronic component such as capacitor can be made by using other dielectric material instead of piezoelectric material.

Third Embodiment

The multi-layer electronic component of the third embodiment of the present invention is a multi-layer piezoelectric element (multi-layer piezoelectric actuator), which is constituted as follows.

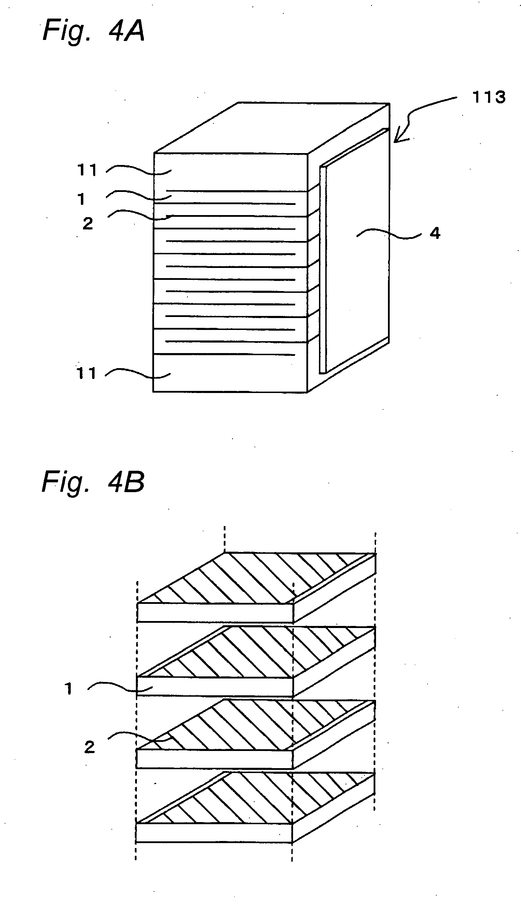

Fig. 4A is a perspective view and Fig. 4B is an exploded perspective view showing the piezoelectric layers and the internal electrodes being stacked one on another.

The multi-layer piezoelectric element of the third embodiment has such a constitution as the external electrodes 4 are formed on a pair of opposing side faces of a stack 113 which comprises the piezoelectric layers 1 and the internal electrodes 2 stacked alternately one on another, wherein the ends of the internal electrodes 2 exposed on the side face in every other layer and the external electrodes 4 are electrically connected with each other, as shown in Fig. 4A and Fig. 4B. The protective layers 11 are formed from the piezoelectric material 1 on both ends in the stacking direction of the stack 113. When the multi-layer piezoelectric element of the third embodiment is used as a multi-layer piezoelectric actuator, the external electrodes 4 may be connected and fixed with lead wires by soldering or the like, and the lead wires may be connected to a power source provided outside.

While the internal electrode 2 is disposed between the piezoelectric layers 1, the internal electrode 2 is formed from a metal such as silver-palladium, and a predetermined voltage is applied via the internal electrode 2 to the piezoelectric layers 1 so as to cause the piezoelectric layer 1 to undergo a displacement by the reverse piezoelectric effect.

The protective layers 11 are a plurality of layers of the piezoelectric material 1 which are not provided with the internal electrodes 2, and therefore do not undergo displacement even when the voltage is applied.

The present invention according to the third embodiment is characterized in that the piezoelectric layer 1 contains 0.01 to 1% by weight of group VIII metal and/or group Ib metal.
The reason for forming the piezoelectric layer to include 0.01 to 1% by weight of group VIII metal and/or group Ib metal is that the volume specific resistance increases when the concentration is in this range and the capability to suppress the metal component from migrating makes it possible to suppress the volume specific resistance from decreasing (aging). Also there is such an advantage that, because the metal component diffuses into the piezoelectric layer 1, ceramic grains grow to the optimum size even when fired at a low temperature of about 1000°C, and the ceramic is fully sintered. When the concentration is less than 0.01% by weight, the amount of the metal component which diffuses into the piezoelectric layer 1 becomes too small, and the effect of accelerating the grain growth cannot be achieved sufficiently, thus resulting in sintering failure. When the concentration is more than 1% by weight, on the other hand, while the effect of accelerating the grain growth is obtained, excessive content of the metal component in the piezoelectric layer 1 decreases the volume specific resistance in the early stage and migration of the metal component may cause short-circuiting in a short period of time after operation.

In order to improve the withstanding voltage and durability of the multi-layer piezoelectric element, the concentration is preferably in a range from 0.01 to 0.7% by weight. In order to improve the piezoelectric characteristic, increase the amount of displacement and improve durability of the multi-layer piezoelectric element, the concentration is more preferably in a range from 0.05 to 0.5% by weight. In order to improve durability of the multi-layer piezoelectric element further, the concentration is furthermore preferably in a range from 0.05 to 0.25% by weight.

In order to improve the piezoelectric characteristic and durability of the multi-layer piezoelectric element, the main metal component of the internal electrode is preferably at least one kind selected from Cu, Ag, Ni, Pt and Pd. In order to improve the piezoelectric characteristic and durability of the multi-layer piezoelectric element further, it is more preferable to include Ag.

Also according to the present invention, it is preferable that concentration of the group VIII metal and/or group Ib metal in the piezoelectric layer 1 is substantially uniform over the entire piezoelectric layers. When the concentration of the group VIII metal and/or group Ib metal in the piezoelectric layers 1 is substantially uniform over the entire piezoelectric layers, grain size distribution in the piezoelectric layers 1 becomes uniform. This results in uniform density distribution of ceramics, thereby improving the durability and the piezoelectric characteristic. Variation in the piezoelectric characteristic can also be minimized. When the concentration distribution is not uniform, cracks may occur during polarization or operation in a portion where the density is lower.

In order to increase the amount of displacement and improve durability of the multi-layer piezoelectric element, therefore, concentration of the metal component in the piezoelectric layer 1 is preferably made uniform. More preferably, standard deviation of concentration of the metal component in the piezoelectric layer 1 is $\sigma = 0.5$ or less, which makes it possible to make the grain size in the piezoelectric layer 1 uniform and improve the durability during operation of the multi-layer piezoelectric element. It is more preferable to control the standard deviation to $\sigma = 0.3$ or less, which makes it possible to improve the withstanding voltage and durability during operation. Also because variation in the piezoelectric characteristic can be decreased, products having the desired piezoelectric characteristic can be made.

Concentrations of group VIII metal and group Ib metal in the piezoelectric layer 1 in terms of weight percent can be determined by EPMA (electron beam probe micro analysis). Quantitative analysis by EPMA was conducted at five points in a surface of the multi-layer piezoelectric element which has been polished to mirror finish, thereby determining calibration curves for intensity (counts) and concentration. Then EPMA line analysis was conducted along the direction of thickness of the multi-layer piezoelectric element, thereby to determine the concentration distribution of the metal component in the piezoelectric layer 1 interposed between the two internal electrodes 2. Since only the count value can be obtained from the EPMA line analysis, concentration distribution of the metal component in the piezoelectric layer 1 was calculated from the calibration line. This value was taken as the concentration and variation of the metal component in the piezoelectric layer 1.

The method for manufacturing the multi-layer piezoelectric element of the third embodiment will be described.

According to the method for manufacturing the multi-layer piezoelectric element of the present invention, first, a calcined powder of a piezoelectric ceramic material constituted from perovskite type oxide consisting of $PbZrO_3$-$PbTiO_3$ or the like, a binder made of an organic polymer such as acrylic resin or butyral resin and a plasticizer such as DBP (dibutyl phthalate) or DOP (dioctyl phthalate) are mixed so as to prepare a slurry. The slurry is formed into ceramic green sheets, which would become the piezoelectric layers 1, by a known method such as doctor blade process or calender roll process or other tape molding method.

Then a metal powder such as silver-palladium that would become the internal electrode 2, a metal oxide such as silver oxide, a binder and a plasticizer are mixed to prepare an electrically conductive paste. This electrically conductive paste is applied onto the top surface of the ceramic green sheets by screen printing method or the like to a thickness of 1 to 40 μm.

A plurality of the green sheets having the electrically conductive paste printed on the top surface thereof are stacked one on another, and the stack is heated at a predetermined temperature to remove the binder, and is then fired at a temperature in a range from 900 to 1200°C thereby to make the stack 113.

In the third embodiment, the manufacturing method described below is employed, thereby making it possible to make the piezoelectric layer 1 which contains 0.01 to 1% by weight of group VIII metal and/or group Ib metal with the concentration of the metal being substantially uniform throughout the piezoelectric layer 1.

First, there is a method to diffuse the metal component sufficiently in the piezoelectric layer 1 by setting the maximum temperature of firing within 1000°C.

There is also such a method as the firing process includes a holding period in which the temperature is kept for 1 to 2 hours within a range (700 to 800°C) which is lower than the maximum temperature by about 200 to 300°C, where the ceramics is not fully sintered and the metal component can diffuse sufficiently.

There is also such a method that it is made easier for the metal component to diffuse by adding about 100ppm of Si, which is a concentration that does not adversely affect the piezoelectric characteristic, to the material used to form the piezoelectric layers 1.

The methods described above make it possible to make the piezoelectric layer 1 which contains 0.01 to 1% by weight of group VIII metal and/or group Ib metal with the concentration of the metal being substantially uniform throughout the piezoelectric layer 1.

When adding the metal powder such as silver-palladium that would become the internal electrode 2 to the green sheets for the portion of the protective layers 11 or when stacking the green sheets for the portion of the protective layers 11, a slurry constituted from the metal powder such as silver-palladium that would become the internal electrode 2, an inorganic compound, a binder and a plasticizer may be printed onto the green sheets, so that the shrinking behavior and shrinkage ratio can be matched between the protective layers 11 and the other portions during sintering, thereby making possible to form a stack having high density.

Method of making the stack 113 is not limited to that described above, and any method may be employed as long as the stack 113 comprising the plurality of piezoelectric layers 1 and the plurality of internal electrodes 2 stacked alternately one on another can be made.

Then silver-glass paste prepared by adding a binder to a mixture of silver and glass is printed on the side faces whereon the external electrodes 4 are to be formed, and is baked at a temperature from 500 to 850°C, so as to form the external electrodes 4.

Then the stack 113 having the external electrodes 4 formed thereon is immersed in a silicone rubber solution while deaerating the silicone rubber solution by evacuation, so as to fill the groove of the stack 113 with the silicone rubber. Then the stack 113 is pulled out of the silicone rubber solution, so that the stack 113 is coated with the silicone rubber on the side faces thereof. Then the silicon rubber that fills the groove and covers the side faces of the column-shaped stack 113 is hardened, thereby completing the multi-layer piezoelectric element of the present invention.

Then lead wires are connected to the external electrodes 4. Through the lead wires, DC voltage of 0.1 to 3 kV/mm is applied between the pair of external electrodes 4 so as to apply polarization treatment to the stack 113, thereby to complete the multi-layer piezoelectric actuator which uses the multi-layer piezoelectric element of the present invention. When the lead wires are connected to an external voltage source and the voltage is supplied via the lead wires and the external electrodes 4 to the internal electrodes 2, the piezoelectric layers 1 undergo a significant amount of displacement by the reverse piezoelectric effect, so as to function, for example, as an automobile fuel injection valve that supplies fuel to an engine.

Preferable forms and examples of components other than those described above in the first through third embodiments will be described below.

As the metal compound in the internal electrode 2 contains group VIII metal and/or group Ib metal as the main component, it is made possible to form the internal electrode 2 from a metal composition which has high heat resistance, and therefore the internal electrode 2 can be fired together with the piezoelectric layer 1 which has a high firing temperature.

It is preferable that such a metal compound is contained in the internal electrode 2 that proportion M1 (% by weight) of group VIII metal and proportion M2 (% by weight) of group Ib metal satisfy relationships of $0 < M1 \leq 15$, $85 \leq M2 < 100$ and $M1 + M2 = 100$.

This constitution enables it to decrease the specific resistance of the internal electrodes 2, and therefore heat generation from the internal electrodes 2 can be suppressed even when the multi-layer piezoelectric element is operated continuously over a long period of time. In addition, since temperature of the multi-layer piezoelectric element can be suppressed from rising, the amount of displacement of the device can be stabilized.

When the proportion of the group VIII metal is higher than 15% by weight, specific resistance of the internal electrode 2 becomes higher which causes the internal electrode 2 to generate heat when the multi-layer piezoelectric element is operated continuously. In order to suppress migration of the group Ib metal contained in the internal electrode 2 into the piezoelectric layers 1, it is preferable to control the proportion of group VIII metal in a range from 0.001 to 15% by weight. In order to improve the durability of the multi-layer piezoelectric element, the proportion is preferably in a range from 0.1 to 10% by weight. When high heat conductivity and even higher durability are required, the proportion is preferably in a range from 0.5 to 9.5% by weight. When it is desired to improve the durability further, the proportion is more preferably in a range from 2 to 8% by weight.

When the proportion of group Ib metal is less than 85% by weight, specific resistance of the internal electrode 2 becomes higher. This may lead to a significant amount of heat generated from the internal electrode 2 during continuous operation of the multi-layer piezoelectric element. In order to suppress the group Ib metal contained in the internal metal 12 from migrating into the piezoelectric layers 1, it is preferable to control the proportion of the group Ib metal in a range from 85 to 99.999% by weight. In order to improve the durability of the multi-layer piezoelectric element, the proportion is preferably in a range from 90 to 99.9% by weight. When higher durability is required, the proportion is preferably in a range from 90.5 to 99.5% by weight. When even higher durability is required, the proportion is more preferably in a range from 92 to 98% by weight.

Concentrations of group VIII metal and group Ib metal in the internal electrode 2 in terms of weight percent can be determined by EPMA (electron beam probe micro analysis) or the like.

Material for the internal electrode 2 is preferably the group VIII metal that is at least one kind selected from among Ni, Pt, Pd, Rh, Ir, Ru and Os, and the group Ib metal that is at least one kind selected from among Cu, Ag and Au, since such a metal composition allows it to use either an alloy material or a mixed powder to form the internal electrodes 2 and is advantageous in volume production when the alloy powder synthesizing technology available today is employed.

Further, it is preferable that the group VIII metal contained in the internal electrode 2 is at least one kind selected from among Pt and Pd, and the group Ib metal is at least one kind selected from among Ag and Au. This composition makes it possible to form the internal electrode 2 which has high heat resistance, high oxidization resistance and low specific resistance.

It is also preferable that the group VIII metal is Ni, because it makes it possible to form the internal electrode 2 which is capable of mitigating the stress generated by the displacement during operation and has high heat resistance.

Further, it is preferable that the group Ib metal is Cu. This composition makes it possible to form the internal electrode 2 which is capable of mitigating the stress generated by the displacement during operation and has high heat conductivity with low hardness.

Moreover, by adding an inorganic compound together with the metal compound in the internal electrode 2, it is made possible to increase the bonding strength between the internal electrode 2 and the piezoelectric layer 1, thereby suppressing peel-off from occurring in the interface between the internal electrode 2 and the piezoelectric layer 1.

It is also preferable that the internal electrode 2 has voids which penetrate therethrough in the direction of thickness. The presence of the voids which penetrate therethrough in the direction of thickness decreases the force of the internal electrode that restricts the displacement of the piezoelectric layer under the influence of the electric field, thus making it easier to undergo displacement and increasing the amount of displacement further. Also because the stress generated in the internal electrode is decreased, durability can also be improved.

The piezoelectric layer 1 preferably has a high value of piezoelectric strain constant $d_{33}$ which represents the piezoelectric characteristic, for example, such as piezoelectric ceramic material which contains perovskite type oxide such as lead titanate zirconate $Pb(Zr-Ti)O_3$ (hereinafter abbreviated as PZT) or barium titanate $BaTiO_3$ as the main component.

When the piezoelectric layer 1 is formed from perovskite type piezoelectric ceramic material such as barium titanate ($BaTiO_3$), high piezoelectric strain constant $d_{33}$ of the material enables it to increase the amount of displacement. This constitution also enables the piezoelectric layer 1 and the internal electrode 2 to be fired at the same time. It is also preferable that the piezoelectric layer 1 contains perovskite type oxide consisting of $PbZrO_3$-$PbTiO_3$, which has a relatively high value of piezoelectric strain constant $d_{33}$, as the main component.

Since the use of perovskite type oxide consisting of $PbZrO_3$-$PbTiO_3$ as the main component of the piezoelectric layer 1 enables the piezoelectric layer 1 and the internal electrode 2 to be fired at the same time, the firing process can be shortened and specific resistance of the internal electrode 2 can be decreased.

The temperature of firing the stack is preferably in a range from 900 to 1000°C. When the firing temperature is lower than 900°C, firing does not proceed sufficiently and it is difficult to make the piezoelectric layer 1 which has sufficiently high density. When the firing temperature is higher than 1000°C, on the other hand, the amount of the metal component which diffuses into the piezoelectric layer 1 increases, thus making short-circuiting likely to occur during polarization and operation with lower durability.

In the multi-layer piezoelectric element of the second embodiment, the internal electrode 2 of which end is exposed on the side face of the stack and the internal electrode 2 of which end is not exposed are stacked alternately, and the groove is formed in the piezoelectric layer disposed between the internal electrode 2 of which end is not exposed and the external electrode 4, as described in the second embodiment. The groove is preferably filled with an insulating material which has Young's modulus lower than that of the piezoelectric layer 12. This constitution makes it possible to mitigate the stress generated by the displacement during operation of the multi-layer piezoelectric element, and suppress heat generation from the internal electrode 2 during continuous operation.

Such a structure as described above may be constituted by, for example, forming the internal electrode 2 of which end is exposed on the side face of the stack and the internal electrode 2 of which end is not exposed alternately, forming the groove in the piezoelectric layer disposed between the internal electrode 2 of which end is not exposed and the external electrode 4, and filling the groove with an insulating material such as resin or rubber which has Young's modulus lower than that of the piezoelectric layer 1. The groove is formed on the side face of the stack 113 by a dicing apparatus or the like.

The electrically conductive material that constitutes the external electrodes 4 is preferably a metal or an alloy which has high electrical conductivity and low Young's modulus such as Ag, Ni, Cu, Al, W, Mo, stainless steel and Fe-Ni-Co alloy, in order to effectively absorb the stress generated by the displacement of the actuator. Among these metals, Ag which has low Young's modulus or an alloy of Ag, Ni and stainless steel are preferable for the reason of high oxidization resistance and high electrical conductivity. In order to make the external electrode 4 which has low resistance and high capability of expanding and contracting so as to accommodate the displacement of the column-shaped stack 102, a mesh member may be provided at the portion where the internal electrode 2 is connected with the external electrode 4 formed with thickness in a range from 50 to 500 μm.

The external electrodes 4 may also be connected to the internal electrode 2, by pressing the external electrodes 4 against the two opposing side faces of the column-shaped stack 102 with an external force. The external electrodes 4 may also be connected and fixed to the internal electrodes 2 by soldering or the like.

The external electrodes may also be formed from a porous electrically conductive material which has a three-dimensional network structure that renders it high elasticity, as described below.

An electrically conductive silver-glass paste is prepared by adding a binder to a glass powder, and the paste is formed into a sheet that is dried to remove solvent while controlling the density of the green sheet in a range from 6 to 9 $g/cm^3$. The sheet is transferred onto the external electrode forming surface of the column-like stack 113, and is baked at a temperature that is higher than the softening point of the glass and is not higher than the melting point (965°C) of silver and is not higher than 4/5 of the firing temperature (°C). In this process, the binder contained in the sheet that is formed from the electrically conductive silver-glass paste is evaporated and removed, so that the external electrode is formed from a porous electrical conductor having a three-dimensional network structure.

The electrically conductive silver-glass paste is preferably baked at a temperature in a range from 550 to 700°C, in order to effectively form a neck portion, achieve bonding with the internal electrode 2 through diffusion of silver which is contained in the electrically conductive silver-glass paste, effectively cause the voids to remain in the external electrode, and partially bond the external electrodes 4 with the side faces of the column-shaped stack 113. Softening point of the glass component contained in the electrically conductive silver-glass paste is preferably in a range from 500 to 700°C.

When the baking temperature is higher than 700°C, sintering of the silver powder contained in the electrically conductive silver-glass paste proceeds excessively, thus making it unable to form a porous electrically conductive material which has an effective three-dimensional network structure. As a result, the external electrode 4 may become too dense which makes the Young's modulus of the external electrode 4 too high to effectively absorb the stress generated during operation, eventually leading to breakage of the external electrode 4. Baking operation is preferably carried out at a temperature not higher than 1.2 times the softening point of the glass.

When the baking temperature is lower than 550°C, diffusion bonding cannot be effectively achieved between the end of the internal electrode 2 and the external electrode 4. As a result, there is a possibility that no neck portion is formed and spark may occur between the internal electrode 2 and the external electrode 4 during operation.

The thickness of the electrically conductive silver-glass paste is preferably smaller than the thickness of the piezoelectric layer 1. The thickness is more preferably 50 $\mu$m or less in order to accommodate the expansion and contraction of the actuator more flexibly.

An electrical conductivity assisting member formed from an electrically conductive adhesive, containing a metal mesh or a mesh-like metal sheet embedded therein, may also be provided on the external surface of the external electrode. By providing the electrical conductivity assisting member on the external surface of the external electrode, it is made possible to flow a large current through the electrical conductivity assisting member even when a large current is caused to flow through the multi-layer piezoelectric element so as to operate at a high speed, thus reducing the current flowing in the external electrodes. This prevents the external electrode from breaking due to localized heating, thus greatly improving the durability. Moreover, the metal mesh or mesh-like metal sheet embedded in the electrically conductive adhesive prevents cracks from occurring in the electrically conductive adhesive.

The metal mesh refers to a structure of entwined metal wires, and the mesh-like metal sheet refers to a metal sheet with a number of holes punched therethrough.

It is further preferable that the electrically conductive adhesive which constitutes the electrical conductivity assisting member is polyimide resin that contains silver powder dispersed therein. By dispersing silver powder of low specific resistance in the polyimide resin which has relatively high heat resistance, it is made possible to form the electrical conductivity assisting member which has low electrical resistance and maintains high bonding strength even when used at a high temperature. The electrically conductive particles are preferably non-spherical particles having such shapes as flakes or acicular particles. When the electrically conductive particles are non-spherical particles such as flakes or acicular particles, the electrically conductive particles can be firmly entwined with each other, thereby increasing the shear strength of the electrically conductive adhesive.

The multi-layer piezoelectric element of the present invention is not limited to those described above, and various modifications may be made without departing from the spirit of the present invention.

While an example of forming the external electrodes 4 on the opposing side faces of the stack 113 has been described above, a pair of electrodes may also be formed, for example, on adjacent side faces, according to the present invention.

Fourth Embodiment

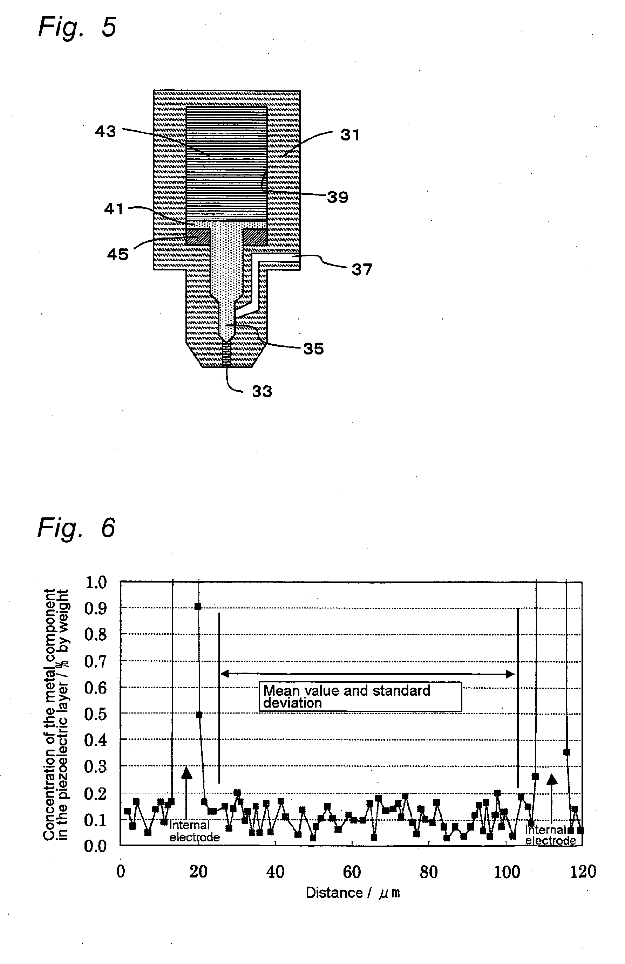

Fig. 5 shows the injection apparatus of the fourth embodiment of the present invention, which comprises a container 31 having an injection hole 33 provided at one end thereof and a needle valve 35 installed in the container 31 so as to open and close the injection hole 33.

The injection hole 33 is provided with a fuel passage 37 disposed so as to communicate therewith. The fuel passage 37 is connected to a fuel source that is provided outside of the apparatus, so as to receive a fuel supplied thereto at a high pressure that remains always constant. When the needle valve 35 opens the injection hole 33, the fuel that fills the fuel passage 37 is injected at a predetermined level of high pressure into a fuel chamber of an internal combustion engine (not shown).

The needle valve 35 has an enlarged top portion where the diameter is made larger, while forming a cylinder 39 housed in the container 31 and a piston 41 which makes sliding motion with respect to the cylinder 39. The multi-layer piezoelectric actuator 43 of the present invention is housed in the container 31.

In such an injection apparatus, when the piezoelectric actuator 43 expands in response to a voltage applied thereto, the piston 41 is pressed so that the needle valve 35 plugs the injection hole 33, thereby stopping the supply of fuel. When the voltage is removed, the piezoelectric actuator 43 shrinks and a Belleville spring 45 pushes back the piston 41, so that the injection hole 33 communicates with the fuel passage 37 and the fuel is discharged.

The present invention relates to the multi-layer piezoelectric element and the injection apparatus, although the present invention is not limited to the embodiment described above, and can be applied to, for example, fuel injection apparatus of automobile engine, liquid injection apparatus of ink jet printer or the like or a drive unit used in precision positioning device or vibration preventing device for an optical apparatus, sensor element mounted in combustion pressure sensor, knocking sensor, acceleration sensor, load sensor, ultrasound sensor, pressure sensor, yaw rate sensor or the like, or used as a circuit component mounted in piezoelectric gyro, piezoelectric switch, piezoelectric transducer, piezoelectric breaker or the like, as long as the piezoelectric property is utilized.

EXAMPLES

Example 1

As Example 1, multi-layer piezoelectric actuator related to the first embodiment of the present invention was made as follows.

First, a calcined powder of a piezoelectric ceramic material constituted from $PbZrO_3$-$PbTiO_3$ as the main component with 3 to 10 mol% of Yb and Ba added as an auxiliary component, a binder and a plasticizer were mixed to form a slurry which was formed into ceramic green sheets that would become the piezoelectric layers 1 having thickness of 100 $\mu$m by the doctor blade process.

An electrically conductive paste, prepared by adding a binder to a powder of silver-palladium alloy was applied to one side of the green sheet with thickness of 3 $\mu$m by screen printing method in a pattern shown in Fig. 2. The electrically conductive paste was printed in such a pattern that forms the positive and negative internal electrodes in symmetrical shape.

Then 300 pieces of the green sheets, 150 sheets for each of the green sheets having the pattern of positive and negative internal electrodes printed thereon, were stacked and 30 pieces of the green sheets without the electrically conductive paste printed thereon were stacked each on the top and the bottom surfaces of the stack in the stacking direction to form the inactive sections. The stack was heated at a predetermined temperature to remove the binder, and was then fired at a temperature in a range from 980 to 1100°C thereby to make the fired stack. The fired stack was trimmed in shape on the side faces and the top and bottom surfaces of the protective layers, to obtain the stack 111 denoted as sample No. 1.

On the stacks 111 obtained as described above, values of L*, a* and b* of the L*a*b* color system were measured in the displacement section 10a, the no-displacement section 10b and the protective layer 11 by means of a spectrocolorimeter (CM-3700d from Konica Minolta Holdings Inc., etc.), and color difference ΔE*ab was calculated. Measuring area was set to 3 mm by 5 mm.

Then silver-glass paste prepared by adding a binder to a mixture of silver powder and glass powder was printed on the side faces of the no-displacement section 10b of the stack 111 to a thickness of 5 to 40 $\mu$m and was, after drying, baked at a temperature of 800°C for 15 minutes so as to form the external electrodes 4.

Then lead wires were connected to the external electrodes and DC electric field of 3 kV/mm was applied through the lead wires between the positive and negative external electrodes for 15 minutes so as to apply polarization treatment, thereby to complete the multi-layer piezoelectric actuator shown in Fig. 1A, which was denoted as sample No. 1.

As Comparative Example, a calcined powder of a piezoelectric ceramic material constituted from $PbZrO_3$-$PbTiO_3$ as the main component with 3 to 10 mol% of Mn and Co added as auxiliary component was used to make the multi-layer piezoelectric actuator by the method described above, which was denoted as sample No. 2.

An operation test was conducted on these multi-layer piezoelectric actuators of sample No. 1 and No. 2 made as described above, by applying an AC electric field varying between 0 and +185V at frequency of 150 Hz at the room temperature, to carry out $1 \times 10^6$ cycles of operation. The multi-layer piezoelectric actuator without insulation failure between the internal electrodes 2 in the initial state was used as sample No. 2. Results of the test are shown in Table 1.

Table 1-1

| No. | Measuring point | Chromaticity | | | | | | |
|---|---|---|---|---|---|---|---|---|
| | | L* | a* | b* | ΔL* | Δa* | Δb* | ΔE*ab |
| 1 | Displacement section | 57.1 | 0.57 | 3.4 | | | | |
| | No-displacement section | 61.2 | 0.48 | 6.3 | | | | |
| | Protective layer | 70.3 | 0.93 | 15.7 | | | | |
| | No-displacement section -displacement section | | | | 4.1 | -0.09 | 2.9 | 5.02 |
| | Protective layer -displacement section | | | | 13.2 | 0.36 | 12.3 | 18.05 |
| | Protective layer - no-displacement section | | | | 9.1 | 0.45 | 9.4 | 13.09 |
| 2 | Displacement section | 55.0 | 0.74 | 1.00 | | | | |
| | No-displacement section | 55.4 | 0.26 | 0.52 | | | | |
| | Protective layer | 55.9 | 0.54 | 1.24 | | | | |
| | No-displacement section - displacement section | | | | 0.4 | -0.48 | -0.48 | 0.79 |
| | Protective layer - displacement section | | | | 0.9 | -0.20 | 0.24 | 0.95 |
| | Protective layer - no- displacement section | | | | 0.5 | 0.28 | 0.72 | 0.92 |

Table 1-2

| Sample No. | After $1 \times 10^6$ cycles of operation | |
|---|---|---|
| | Damage by short-circuiting | Crack |
| 1 | None | None |
| *2 | Occurred | Occurred |

As shown in Table 1, the multi-layer piezoelectric actuator of sample No. 2 made as Comparative Example had borders, all not clear, between the displacement section and the no-displacement section, between the displacement section and the protective layer and between the no-displacement section and the protective layer, because the color difference ΔE*ab was not higher than 1.0. As a result, when the external electrodes 4 were formed, the external electrode 4 and the internal electrode 2 of the opposite polarity exposed on the side face of the displacement section 10a were not isolated from each other by a sufficient space therebetween. As a result, short-circuiting occurred between the external electrode 4 and the internal electrode 2 of the opposite polarity exposed on the side face of the displacement section 10a, thus resulting in destruction during operation.

Also because the borders between the displacement section and the protective layer and between the no-displacement section and the protective layer were not clear, namely the border between the effective layer 10 and the protective layer 11 was not clear, it was difficult to polish the protective layer 11 for the purpose of improving the dimensional accuracy, and variation occurred in the thickness of the protective layer 11 thus resulting in cracks occurring in thin portions of the protective layer 11.

In the multi-layer piezoelectric actuator of sample No. 1 made as Example of the present invention, in contrast, the color difference ΔE*ab was not lower than 1.0 between the displacement section and the no-displacement section and between the effective section 10 and the protective layer 11, and therefore the borders were clear. As a result, the external electrodes 4 were formed on the side face of the no-displacement section 10b, and 0.5 mm or more space of isolation was secured between the external electrodes 4 and the internal electrode 2 of the opposite polarity which was exposed on the side face of the displacement section 10a. As a result, short-circuiting did not occur between the external electrode 4 and the internal electrode 2 of the opposite polarity exposed on the side face of the displacement section 10a. Also because the protective layers 11 provided on the top and the bottom had thickness of 1 mm or more, crack did not occur after continuous operation.

Example 2

First, a calcined powder of a piezoelectric ceramic material constituted from PZT as the main component, a binder made of butyral, a solvent made of IPA-toluene and a plasticizer were mixed to prepare a slurry shown in the Table which was formed into ceramic green sheets having thickness of 100 $\mu$m by the slip casting process, after measuring the viscosity.

An electrically conductive paste having the composition shown in the table was applied to one side of the green sheet with thickness of 5 $\mu$m by screen printing method and was dried. Then 100 pieces of the green sheets having the electrically conductive paste printed thereon were stacked, and the green sheets without the electrically conductive paste printed thereon were stacked, 10 pieces on the top and 20 pieces on the bottom of the stack in the stacking direction.

The stack was pressurized while heating to 100°C so as to consolidate, and was cut into square prism shape measuring 8 mm by 8 mm. After heating to 800°C for 10 hours so as to remove the binder, the piezoelectric layers 1 and the internal electrodes 2 were heated at the same time to 1000°C for 2 hours so as to obtain the column-shaped stack 102 shown in Fig. 1. In the firing process, an enclosed crucible made of MgO was used to fire the stack with a powder having the same composition as that of the stack put therein.

Four side faces of the column-shaped stack 102 were ground.

Then a groove having depth of 200 $\mu$m and width of 75 $\mu$m in the stacking direction was formed in every other layer on the end face of the piezoelectric layer 1 which included the end of the internal electrodes 2, alternately on the two opposing side faces of the column-shaped stack 102. The grooves were filled with silicone rubber to form the insulator 3, with the end of the internal electrodes 2 being exposed alternately on the two opposing side faces of the column-shaped stack 102 in every other layer.

An electrically conductive adhesive made from silver and polyimide resin was applied to the two opposing side faces of the column-shaped stack 102 and, with a mesh member embedded in the electrically conductive adhesive, the stacked was heated 200°C so as to harden the adhesive, thereby forming the external electrodes 4.

Then the lead wires 6 were connected to the external electrodes 4 by soldering. After cleaning the external surface of the actuator with alcohol, the surface was treated with primer or the like to improve the bonding property with resin before being coated with a silicone rubber by dipping or other process. Then polarization voltage of 1 kV was applied so as to polarize the actuator as a whole, thereby obtaining the multi-layer piezoelectric actuator of the present invention shown in Fig. 1.

When a DC voltage of 200V was applied to the multi-layer piezoelectric actuator thus obtained, the actuators underwent displacement of 10 $\mu$m.

Operation test was conducted by applying AC electric field varying between 0 and +200V at frequency of 200 Hz to the multi-layer piezoelectric actuator at 150°C. In the operation test, displacement was measured after subjecting the multi-layer piezoelectric actuator to $1 \times 10^9$ cycles of operations, so as to determine the difference from the initial amount of displacement. Samples showing a change in the amount of displacement within 0.5 $\mu$m were evaluated as normal. The change in the amount of displacement was measured at 3 points at the center and periphery of the multi-layer piezoelectric actuator by means of a laser displacement meter, with the sample being secured on a vibration-free test stage and an aluminum foil attached on the top surface of the sample, and averaging the measurements.

The thickness of the piezoelectric layer 1 was measured in a section of the sample after operation test. Thickness was measured at arbitrarily selected 10 points for each of 5 arbitrarily selected piezoelectric layers by using SEM photograph of the section, and the difference between the maximum value and the minimum value was taken as the variation. The results are shown in Table 2.

Table 2

| Sample No. | Binder | Solvent | Viscosity (Poise) | Thickness of piezoelectric layer ($\mu$m) | Variation in thickness ($\mu$m) | Change in the amount of displacement |
|---|---|---|---|---|---|---|
| *1 | | Water | 10 | 100 | 15 | Destroyed by short-circuiting between electrodes |
| 2 | Acryl 1 | IPA-toluene | 20 | 100 | 9 | 0.4 $\mu$m |
| 3 | Acryl | IPA-toluene | 25 | 100 | 7 | No change |
| 4 | Acryl | IPA-toluene | 30 | 100 | 3 | No change |

(continued)

| Sample No. | Binder | Solvent | Viscosity (Poise) | Thickness of piezoelectric layer ($\mu$m) | Variation in thickness ($\mu$m) | Change in the amount of displacement |
|---|---|---|---|---|---|---|
| 5 | Butyral | IPA- toluene | 25 | 100 | 7 | No change |
| 6 | Acryl | IPA-toluene | 25 | 50 | 3 | 0.4 $\mu$m |
| 7 | Acryl | IPA-toluene | 25 | 60 | 3 | No change |
| 8 | Acryl | IPA-toluene | 25 | 70 | 5 | No change |
| *9 | Acryl | IPA- toluene | 25 | 30 | 3 | Destroyed during polarization |
| Samples marked with * are out of the scope of the present invention. | | | | | | |

Change in the amount of displacement is given in terms of the difference between the initial amount of displacement and the amount of displacement measured after $1 \times 10^9$ cycles of operations.

As shown in Table 2, sample No. 1 made as Comparative Example in which variation in thickness exceeded 10 $\mu$m experienced short-circuiting between internal electrodes 2 after $1 \times 10^7$ cycles of operations. Sample No. 9 was destroyed during polarization because thickness of the piezoelectric layer 1 was small and the distance between the internal electrodes was too small.

In Example 2 of the present invention (samples Nos. 2, 3, 4, 5, 6, 7, 8) where thickness of the piezoelectric layer 1 was 50 $\mu$m or more and variation in thickness was 10 $\mu$m or less, short-circuiting between the ends of internal electrodes 2 could be suppressed.

Example 2 of the present invention (samples Nos. 3, 4, 5, 7, 8), in particular, where thickness was 60 $\mu$m or more and variation in thickness was 7 $\mu$m or less, showed the best results.

Example 3

In Example 3, the multi-layer piezoelectric actuator of the present invention was made and evaluated as described below.

First, a calcined powder of a piezoelectric ceramic material constituted from lead titanate zirconate ($PbZrO_3$-$PbTiO_3$) having a mean particle size of 0.4 $\mu$m as the main component, a binder and a plasticizer were mixed to prepare a slurry which was formed into ceramic green sheets that would become the piezoelectric layers 1 having thickness of 150 $\mu$m by the doctor blade process.

An electrically conductive paste, prepared by adding silver oxide and a binder to silver-palladium alloy which was prepared in an arbitrary ratio of composition, was applied to one side of the ceramic green sheet to a thickness of 3 $\mu$m by screen printing method. Then 300 pieces of the ceramic green sheets were stacked and fired at a temperature of 1000°C after holding the temperature at 800°C.

Then a groove having depth of 50 $\mu$m and width of 50 $\mu$m was formed on the end face of the internal electrode in every other layer on the side face of the stack by a dicing apparatus.

Then to a mixture of 90% by volume of silver powder consisting of flake-like particles having a mean particle size of 2 $\mu$m and 10% by volume of amorphous glass powder having softening point of 640°C containing silicon having a mean particle size of 2 $\mu$m as the main component, 8 weight parts of binder and 100 weight parts in total of silver powder and glass powder were added, so as to prepare the electrically conductive silver-glass paste by fully mixing the powders. The electrically conductive silver-glass paste thus prepared was applied onto a release film by screen printing. After drying, the paste film was peeled off the release film to obtain a sheet of electrically conductive silver-glass paste. Density of the green sheet was measured by Archimedes method, and a value of 6.5 g/cm$^3$ was obtained.

The sheet of the silver-glass paste was transferred onto the surface of the external electrode 4 of the stack 113, and was baked at 650°C for 30 minutes, thereby forming the external electrode 4 from a porous electrical conductor having a three-dimensional network structure. Measurement of the void ratio of the external electrode 4 by analyzing a photograph of a cross section of the external electrode 4 with an image analysis apparatus showed a value of 40%.

Then lead wires were connected to the external electrodes 4 and DC electric field of 3 kV/mm was applied through the lead wires between the positive and negative external electrodes 4 for 15 minutes so as to apply polarization treatment, thereby to complete the multi-layer piezoelectric actuator using the multi-layer piezoelectric element shown in Fig. 4.

DC voltage was applied to the multi-layer piezoelectric element, and the intensity of the electric field which caused destruction was determined. The number of cycles which caused destruction under the input of 150V rectangular wave is shown in Table 3.

Quantitative analysis by EPMA was conducted at five points of the piezoelectric layer 1 interposed between the internal electrodes in the multi-layer piezoelectric element which had been polished to mirror finish, thereby determining calibration curves for intensity (counts) and concentration. Then EPMA line analysis was conducted along the direction of thickness of the multi-layer piezoelectric element, thereby to determine the concentration distribution of the metal component in the piezoelectric layer 1 interposed between the two internal electrodes 2. Since only the count value can be obtained from the EPMA line analysis, concentration distribution of the metal component in the piezoelectric layer 1 was calculated from the calibration curve. The results are shown in Fig. 6. Mean value and standard deviation of concentration of the metal component in the piezoelectric layer 1 were determined from the data of about 40 points.

Table 3

| No. | Firing temperature (°C) | Silver content in piezoelectric layer (% by weight) | Variation in diffusion ($\delta$) | Insulation breaking down electric field (kV/mm) | Number of cycles at breakage (times) |
|---|---|---|---|---|---|
| *1 | 800 | 0.003 | - | 1.0 | Destroyed during polarization |
| 2 | 850 | 0.01 | 0.5 | 4.2 | $1 \times 10^9$ |
| 3 | 890 | 0.05 | 0.3 | 5.4 | $2 \times 10^9$ |
| 4 | 900 | 0.09 | 0.2 | 10.5 | $3 \times 10^9$ |
| 5 | 950 | 0.15 | 0.2 | 11.2 | $3 \times 10^9$ |
| 6 | 1,000 | 0.25 | 0.3 | 10.1 | $3 \times 10^9$ |
| 7 | 1,020 | 0.3 | 0.5 | 7.3 | $2 \times 10^9$ |
| 8 | 1,050 | 0.4 | 0.5 | 6.3 | $2 \times 10^9$ |
| 9 | 1,100 | 0.7 | 0.5 | 5.4 | $1 \times 10^9$ |
| 10 | 1,150 | 1.0 | 0.5 | 5.2 | $1 \times 10^9$ |
| *11 | 1,200 | 2.0 | 1.0 | 3.5 | $1 \times 10^8$ |
| *12 | 1,250 | 3.0 | 1.0 | 3.2 | $1 \times 10^8$ |

From Table 3, it can be seen that the piezoelectric layer cannot be fully sintered when the amount of silver diffusing into the piezoelectric layer is less than 0.01% by weight (sample No. 1), resulting in destruction during polarization. When the amount of silver diffusing into the piezoelectric layer is in a range from 0.01 to 1% by weight (samples Nos. 2 through 10), the amount of diffusion involves less variation, the electric field causing insulation break down is higher, the number of cycles which lead to destruction is larger and durability is improved. Samples Nos. 11 and 12 show that higher firing temperature and larger amount of diffusion of silver made migration easier to occur. So the electric field causing insulation break down and the number of cycles which lead to destruction become lower.

The multi-layer piezoelectric element of the present invention is not limited to Example 3, and various modifications may be made without departing from the spirit of the present invention.

INDUSTRIAL APPLICABILITY

The multi-layer electronic component of the present invention can be used in a multi-layer ceramic capacitor or piezoelectric transducer. The multi-layer electronic component of the present invention can also be used as a multi-layer piezoelectric actuator which is used in a fuel injection apparatus of automobile engine, or a drive unit used in precision positioning device or vibration preventing device for an optical apparatus. The multi-layer electronic component of the present invention can be used in an injection apparatus for the automobile fuel, the ink of ink jet printer or the like.

**Claims**

1.  A multi-layer electronic component comprising:

    a stack having an effective region formed by stacking at least one dielectric layer and a plurality of internal electrodes consisting of first and second internal electrodes one on another and protective layers provided on both ends of the effective region in the stacking direction; and
    external electrodes formed on two side faces of the stack with one of which being connected to the first internal electrode and the other external electrode being connected to the second internal electrode,
    wherein the effective region consists of an active region where adjacent first internal electrode and second internal electrode oppose each other and an inactive region located outside of the active region in which the first internal electrodes or the second internal electrodes oppose each other, and
    wherein the active region and the inactive region have different colors.

2.  The multi-layer electronic component according to claim 1,
    wherein a color difference ΔE*ab in the L*a*b* color system between the active region and the inactive region is 1.0 or larger.

3.  A multi-layer electronic component comprising:

    a stack having an effective region formed by stacking at least one dielectric layer and a plurality of internal electrodes consisting of first and second internal electrodes one on another and protective layers provided on both ends of the effective region in the stacking direction; and
    external electrodes formed on two side faces of the stack with one of which being connected to the first internal electrode and the other external electrode being connected to the second internal electrode,
    wherein the effective region and the protective layers have different colors.

4.  The multi-layer electronic component according to claim 3,
    wherein a color difference ΔE*ab in the L*a*b* color system between the effective region and the protective layers is 1.0 or larger.

5.  The multi-layer electronic component according to claims 2 or 4,
    wherein the dielectric layers and the internal electrodes have different colors and a color difference ΔE*ab in the L*a*b* color system between the dielectric layers and the internal electrodes is 1.5 or larger.

6.  The multi-layer electronic component as in one of claims 1 to 5,
    wherein the dielectric layer is a piezoelectric layer, the active region is a displacement section and the inactive region is a no-displacement section.

7.  A multi-layer electronic component comprising: a stack made by stacking a plurality of dielectric layers and a plurality of internal electrodes,
    wherein the dielectric layer has thickness of 50 μm or more and variation in the thickness of the dielectric layer is 10 μm or less.

8.  The multi-layer electronic component according to claim 7,
    wherein the dielectric layer includes a perovskite type oxide as a main component.

9.  A multi-layer electronic component comprising:

    a stack formed by stacking at least one piezoelectric layer and a plurality of internal electrodes consisting of first and second internal electrodes one on another; and
    external electrodes formed on two side faces of the stack with one of which being connected to the first internal electrode and the other external electrode being connected to the second internal electrode,
    wherein the piezoelectric layer contains 0.01 to 1% by weight of group VIII metal and/or group Ib metal.

10. The multi-layer electronic component according to claim 9,
    wherein a concentration of the group VIII metal and/or group Ib metal in the piezoelectric layer 1 is substantially uniform over the entire piezoelectric layers.

**11.** The multi-layer electronic component as in one of claims 6, 9 and 10,
wherein the dielectric layer includes a perovskite type oxide as a main component.

**12.** The multi-layer electronic component according to claims 8 or 11,
wherein the perovskite type oxide contains $PbZrO_3$-$PbTiO_3$ as a main component.

**13.** The multi-layer electronic component as in one of claims 6, 9, 10, 11 and 12,
wherein the stack has grooves formed between the second internal electrodes and the external electrode in one side face of the two side faces and a grooves formed between the first internal electrodes and the external electrode in the other side face, and
wherein the grooves are filled with an insulating material which has Young's modulus lower than that of the piezoelectric layer.

**14.** The multi-layer electronic component as in one of claims 1 to 13,
wherein a metal compound in the internal electrode contains group VIII metal and/or group Ib metal as the main component.

**15.** The multi-layer electronic component according to claim 14,
wherein relationships of $0 < M1 \leq 15$, $85 \leq M2 < 100$ and $M1 + M2 = 100$ are satisfied in which group VIII metal content is M1% by weight and group Ib metal content is M2% by weight.

**16.** The multi-layer electronic component as in one of claims 9 to 11, 14 and 15,
wherein the group VIII metal is a metal is at least one kind selected from a group consisting of Ni, Pt, Pd, Rh, Ir, Ru and Os and the group Ib metal is at least one kind selected from a group consisting of Cu, Ag and Au.

**17.** The multi-layer electronic component as in one of claims 9 to 11, 14 and 15,
wherein the group VIII metal is at least one kind selected from a group consisting of Pt and Pd, and the group Ib metal is at least one kind selected from a group consisting of Ag and Au.

**18.** The multi-layer electronic component as in one of claims 9 to 11, 14 and 15,
wherein the group VIII metal is Ni.

**19.** The multi-layer electronic component as in one of claims 9 to 11, 14 and 15,
wherein the group Ib metal is Cu.

**20.** The multi-layer electronic component as in one of claims 1 to 19,
wherein an inorganic compound is contained together with the metal compound in the internal electrode.

**21.** The multi-layer electronic component according to claim 20,
wherein the inorganic compound is a perovskite type oxide consisting of $PbZrO_3$- $PbTiO_3$ as a main component.

**22.** The multi-layer electronic component as in one of claims 9 to 21,
wherein the stack is fired at a temperature in a range not less than 900°C nor higher than 1200°C.

**23.** The multi-layer electronic component as in one of claims 1 to 22,
wherein the internal electrode has voids which penetrate therethrough in the direction of thickness of the internal electrode.

**24.** An injection apparatus comprising:

a container having an injection hole;
a multi-layer electronic component as in one of claims 1 to 23 which undergoes expansion and contraction in the stacking direction in response to a voltage applied between the first and second internal electrodes; and
a valve which allows a liquid to spout out of the injection hole when the multi-layer electronic component is driven to operate.

**25.** A method of manufacturing a multi-layer electronic component comprising:

preparing dielectric material sheets having thickness of 50 $\mu$m or more and variation in the thickness within 10 $\mu$m from a slurry which contains a dielectric material by a tape forming method;
printing the internal electrodes on the sheets;
stacking the sheets and firing.

26. The method of manufacturing a multi-layer electronic component according to claim 25, further comprising, adjusting a viscosity of the slurry to 15 poise or higher before preparing dielectric material sheets.

27. The method of manufacturing a multi-layer electronic component according to claims 25 or 26,
wherein the slurry contains at least one kind selected from a group consisting of acrylic resin and butyral resin as a binder, and at least one kind selected from a group consisting of alcohol and toluene as a solvent.

*Fig. 1A*

*Fig. 1B*

## Fig. 1C

## Fig. 2

*Fig. 3*

*Fig. 4A*

*Fig. 4B*

## Fig. 5

## Fig. 6

*Fig. 7*

<table>
<tr><td colspan="2" align="center">**INTERNATIONAL SEARCH REPORT**</td><td>International application No.<br>PCT/JP2005/011539</td></tr>
</table>

| | |
|---|---|
| A. CLASSIFICATION OF SUBJECT MATTER<br>    Int.Cl⁷  H01L41/083, 41/187, 41/22, H02N2/00 | |

According to International Patent Classification (IPC) or to both national classification and IPC

B.  FIELDS SEARCHED

Minimum documentation searched (classification system followed by classification symbols)
    Int.Cl⁷  H01L41/083, 41/187, 41/22, H02N2/00

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2005 |
| Kokai Jitsuyo Shinan Koho | 1971-2005 | Toroku Jitsuyo Shinan Koho | 1994-2005 |

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
|---|---|---|
| X | JP 2004-59335 A  (Murata Mfg. Co., Ltd.),<br>26 February, 2004 (26.02.04),<br>Par. Nos. [0017] to [0022]; Fig. 1<br>& US 2004/021399 A1     & CN 1473793 A | 1-2,5 |

☐  Further documents are listed in the continuation of Box C.          ☐  See patent family annex.

| | |
|---|---|
| *    Special categories of cited documents:<br>"A"  document defining the general state of the art which is not considered to be of particular relevance<br>"E"  earlier application or patent but published on or after the international filing date<br>"L"  document which may throw doubts on priority claim(s) or which is cited to establish the publication date of another citation or other special reason (as specified)<br>"O"  document referring to an oral disclosure, use, exhibition or other means<br>"P"  document published prior to the international filing date but later than the priority date claimed | "T"  later document published after the international filing date or priority date and not in conflict with the application but cited to understand the principle or theory underlying the invention<br>"X"  document of particular relevance; the claimed invention cannot be considered novel or cannot be considered to involve an inventive step when the document is taken alone<br>"Y"  document of particular relevance; the claimed invention cannot be considered to involve an inventive step when the document is combined with one or more other such documents, such combination being obvious to a person skilled in the art<br>"&"  document member of the same patent family |

| | |
|---|---|
| Date of the actual completion of the international search<br>    12 September, 2005 (12.09.05) | Date of mailing of the international search report<br>    27 September, 2005 (27.09.05) |
| Name and mailing address of the ISA/<br>    Japanese Patent Office | Authorized officer |
| Facsimile No. | Telephone No. |

Form PCT/ISA/210 (second sheet) (January 2004)

## INTERNATIONAL SEARCH REPORT

| International application No. |
| --- |
| PCT/JP2005/011539 |

---

**Box No. II        Observations where certain claims were found unsearchable (Continuation of item 2 of first sheet)**

This international search report has not been established in respect of certain claims under Article 17(2)(a) for the following reasons:

1. ☐ Claims Nos.:
   because they relate to subject matter not required to be searched by this Authority, namely:

2. ☐ Claims Nos.:
   because they relate to parts of the international application that do not comply with the prescribed requirements to such an extent that no meaningful international search can be carried out, specifically:

3. ☐ Claims Nos.:
   because they are dependent claims and are not drafted in accordance with the second and third sentences of Rule 6.4(a).

---

**Box No. III        Observations where unity of invention is lacking (Continuation of item 3 of first sheet)**

This International Searching Authority found multiple inventions in this international application, as follows:
There must exist a special technical feature so linking a group of inventions of claims as to form a single general inventive concept in order that the group of inventions may satisfy the requirement of unity of invention.  The group of inventions of claims 1-27 is considered to be linked only by the technical feature of being "a multilayer electronic component".

(Continued to extra sheet)

1. ☐ As all required additional search fees were timely paid by the applicant, this international search report covers all searchable claims.

2. ☐ As all searchable claims could be searched without effort justifying an additional fee, this Authority did not invite payment of any additional fee.

3. ☐ As only some of the required additional search fees were timely paid by the applicant, this international search report covers only those claims for which fees were paid, specifically claims Nos.:

4. ☒ No required additional search fees were timely paid by the applicant.   Consequently, this international search report is restricted to the invention first mentioned in the claims; it is covered by claims Nos.: 1-2, 5

**Remark on Protest**        ☐ The additional search fees were accompanied by the applicant's protest.

                          ☐ No protest accompanied the payment of additional search fees.

Form PCT/ISA/210 (continuation of first sheet (2)) (January 2004)

| INTERNATIONAL SEARCH REPORT | International application No. |
|---|---|
| | PCT/JP2005/011539 |

Continuation of Box No.III of continuation of first sheet(2)

This technical feature, however, cannot be a special technical feature since it is disclosed in a prior art document JP 2004-59335 A (Murata Mfg. Co., Ltd.), 26 February, 2004 (26.02.04), Par. Nos. [0017]-[0022], Fig. 1.

Consequently, there is no special technical feature so linking the group of inventions of claims 1-27 as to form a single general inventive concept.

Therefore, it appears that the group of inventions of claims 1-27 does not satisfy the requirement of unity of invention.

Then, judging from the specific modes described in the independent claims, the claims of this international application are considered to define five groups of inventions: the invention of claims 1-2, 5-6, 11-15, 20-21, 23-24; the invention of claims 3-4; the invention of claims 7-8; the invention of claims 9-10, 16-19, 22; and the invention of claims 25-27.

Further, unity of invention is examined with respect to claims 1-2, 5-6, 11-15, 20-21, 23-24.

The group of inventions of claims 1-2, 5-6, 11-15, 20-21, 23-24 is considered to be linked only by the technical feature of being "a multilayer electronic component comprising a multilayer body including an effective layer wherein at least one dielectric body and a plurality of internal electrodes composed of first and second internal electrodes are alternately arranged in layers and protective layers arranged on both ends of the effective layer in the layer-stacking direction, and external electrodes respectively formed on two lateral surfaces of the multilayer body, with one of the external electrodes being connected to the first internal electrodes and the other being connected to the second internal electrodes; which multilayer electronic component is characterized in that the effective layer has an active portion wherein adjacent first internal electrode and second internal electrode are opposite to each other and an inactive portion located outside the active portion in which inactive portion two first internal electrodes or two second internal electrodes are opposite to each other, and the color of the active portion is different from the color of the inactive portion".

This technical feature, however, is disclosed in the above-mentioned prior art document, and thus judging from the specific modes described in the claims 1-2, 5-6, 11-15, 20-21, 23-24, these claims are considered to define the following six inventions: the invention of claims 1-2, 5; the invention of claims 6, 11-13; the invention of claims 14-15; the invention of claims 20-21; the invention of claim 23; and the invention of claim 24. Consequently, claims 1-27 of this international application are considered to contain ten inventions.

Form PCT/ISA/210 (extra sheet) (January 2004)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2001181055 A
- JP 61133715 A

- JP 12508835 W